# EUROPÄISCHE PATENTSCHRIFT

(11) **EP 2 133 567 B1**
(45) Veröffentlichungstag und Bekanntmachung des Hinweises auf die Patenterteilung: **07.05.2014**
(21) Anmeldenummer: 08019879.9
(22) Anmeldetag: 14.11.2008
(51) Int. Cl.: F04B 17/00

(54) **Elektrischer Schwingantrieb**
Electrical vibration drive
Commande oscillante électrique

(30) Priorität: 10.06.2008 DE 202008007730 U
(43) Veröffentlichungstag der Anmeldung: 16.12.2009
(73) Patentinhaber: Richter, Siegfried, 88605 Sauldorf-Rast (DE)
(72) Erfinder: Richter, Siegfried, 88605 Sauldorf-Rast (DE)
(74) Vertreter: Binner, Bernhard

(56) Entgegenhaltungen:
- EP-A2- 1 898 087
- US-A- 5 934 882

## Beschreibung

Die Erfindung betrifft einen elektrischen Schwingantrieb mit wenigstens einem von einem periodische Kraftimpulse mit kleiner Bewegungsamplitude erzeugenden Aktuator, insbesondere einem Piezo-Aktuator oder einem Schwingankermagneten, mit angepasster Eigenfrequenz in einer vorgegebenen Ebene schwingend angetriebenen Schwingsystem, das wenigstens einen pendelartige Schwingbewegungen ausführenden Schwingarm mit einer Resonanzmasse und mit einem Balancearm aufweist, der über ein Kopplungsglied des Balancearms mit einem oszillierend anzutreibenden Arbeitsorgan eines Arbeitsgerätes, insbesondere einer Pumpe, in mechanischer Antriebsverbindung steht.

Aus DE 10 2006 043 219 B3 ist ein piezoelektrischer Pumpenantrieb, insbesondere für Luftpumpen bekannt, bei dem als Arbeitsorgan eine Membrane von einem Resonanzschwingsystem oszillierend angetrieben wird. Dieses Resonanzschwingsystem weist wenigstens eine als Blattfeder ausgebildete Resonanzfeder auf, welche den Schwingarm bildet und welche an einem langen Hebelarm die Resonanzmasse trägt. Dieser lange, die Resonanzmasse tragende Schwingarm wird über einen kurzen Antriebshebel von einem Piezoelement oszillierend angetrieben, d.h. in Schwingung versetzt. Der mit einem Ende an einem Gestell ortsfest fixierte Antriebshebel und die Resonanzfeder sind einstückig miteinander verbunden, d.h. sie bilden gemeinsam ein Bauteil. Durch die Verwendung einer Blattfeder als Resonanzfeder lässt sich die Schwingungsrichtung in eine bestimmte Ebene einfach festlegen, und durch die Anwendung unterschiedlicher Hebelarme des kürzeren Antriebshebels einerseits und des längeren Schwingarms andererseits ergeben sich Hebelübersetzungen und damit Bewegungsübersetzungen zwischen dem Antriebshebel und der Resonanzfeder, durch die sich hohe Arbeitsleistungen bei hohen Wirkungsgraden erzielen lassen. Die Resonanzfeder bzw. der Schwingarm ist bei verschiedenen Ausführungsformen dieses bekannten Piezo-Antriebs an dem mit der Resonanzmasse versehenen Ende mit einem rückwärts gebogenen, parallel zur Resonanzfeder verlaufenden Endabschnitt versehen, an dem eine sog. Balancemasse befestigt ist. Diese an dem als Balancearm wirkenden Endabschnitt der Resonanzfeder befestigte Balancemasse bewirkt eine zumindest annähernde Parallelschwingung des Endabschnitts bzw. Balancearms zu seiner Erstreckung, d.h. zu sich selbst. Ob diese Parallelschwingung tatsächlich erreicht wird, hängt unter anderem auch von dem Grad der Biegeelastizität des Balancearms und der Resonanzfeder ab. Weil bei diesem bekannten piezoelektrischen Pumpenantrieb sowohl die Resonanzfeder als auch der Balancearm aus einer Blattfeder bestehen, ist für beide eine hohe Biegeelastizität anzunehmen. Eine hohe Biegelastizität kann aber zu einem von der Parallelität abweichenden Schwingverhalten führen. Bei dieser bekannten Ausführungsform ist der die Resonanzmasse tragende Abschnitt der Resonanzfeder oder die Resonanzmasse selbst unmittelbar über geeignete Kopplungselemente mit dem Arbeitsorgan des Arbeitsgerätes, d.h. mit der Pumpmembrane der Fluidpumpe verbunden. Die dabei an dem mit dem Verbindungsbogen verbundenen Endabschnitt des Balancearms befestigte Resonanzmasse und das mit ihr verbundene Kopplungselement führen keine reine Parallelschwingung zur Erstreckungsebene des Balancearms aus, sondern eine bogenförmige Bewegung, was sich schädlich auf das Arbeitsorgan, d.h. auf die Pumpmembrane auswirken kann.

Eine andere Ausführungsform dieses bekannten piezoelektrischen Pumpenantriebs ist mit einer Resonanzfeder versehen, die drei jeweils durch sich über 180° erstreckende und somit rückwärts gerichtete Bogenabschnitte einstückig miteinander verbundene, S-förmig parallel zueinander verlaufende Federschenkel aufweist. Die Resonanzmasse ist dabei in der Nähe des ersten Bogenabschnitts am mittleren Federschenkel angeordnet. Die Balancemasse befindet sich am freien Ende des dritten Federschenkels. Etwa in der Längsmitte dieses dritten Federschenkels befindet sich auch das Kopplungselement, das diesen Federschenkel mit der Pumpenmembrane verbindet. Bei dieser Ausführung kann angenommen werden, dass der dritte Federschenkel parallel zu sich selbst bzw. zu seiner Erstreckungsebene schwingt und dass seine Bewegungen sich nicht schädlich auf die Pumpenmembrane auswirken.
Eine dreischenklige Resonanzfeder ist jedoch insofern von Nachteil, als sie mehr Raum beansprucht als eine nur zweischenklige Feder und dass sie leichter außer Tritt fallen kann, also störanfälliger ist. Außerdem ist es schwieriger, eine dreischenklige Resonanzfeder auf die adäquate Eigenfrequenz abzustimmen als eine zweischenklige.
Bei dieser bekannten Antriebsvorrichtung bestehen die Resonanzfeder und die Balancefeder jeweils aus Blattfedern mit hoher Federelastizität, was erfahrungsgemäß beim Auftreten einer Widerstandskraft eher zu Resonanzabweichungen und damit zu Betriebsstörungen führen kann.

Der Erfindung liegt die Aufgabe zugrunde, einen elektrischen Schwingantrieb der eingangs genannten Art zu schaffen, der in kompakter Bauweise einfach und kostengünstig herstellbar ist und mit hoher Effektivität und langer Lebensdauer störungsfrei arbeitet.

Gelöst wird diese Aufgabe erfindungsgemäß bei einfacher Ausführung dadurch, dass der Schwingarm an zwei ungleich langen Hebeln, nämlich einem Lenkerhebel und einem Antriebshebel, befestigt ist, wobei wenigstens einer dieser beiden Hebel, insbesondere der Lenkerhebel, wenigstens abschnittweise biegeelastisch ausgebildet ist und sein nicht mit dem Schwingarm verbundenes Ende an einer vom Schwingarm entfernten Stelle unbeweglich mit einem Gestellteil verbunden ist in dem der Aktuator gelagert ist, und wobei der Antriebshebel mit dem Aktuator derart in bewegungsübertragender Verbindung steht, dass die Kraftimpulse des Aktuators dem Schwingarm zur Erzeugung seiner Pendelschwingung in einer Richtung zugeführt werden, die zumindest annähernd parallel zu dessen Erstreckungsrichtung in der Ruhelage verläuft.

Ein mit diesen Merkmalen ausgestatteter Schwingantrieb lässt sich einfach und kostensparend realisieren, indem die Bestandteile des Schwingsystems, welche die Resonanzmasse und die Balancemasse tragen, zusammen mit dem Lenkerhebel und dem Antriebshebel einstückig aus formstabilem Kunststoff als Spritzgussteil hergestellt werden können. Die für eine optimale Funktionsweise erforderlichen Eigenschaften der Formstabilität und der Biegeelastizität können durch Auswahl des geeigneten Kunststoffs, z.B. Delrin oder Polyamid, und durch geeignete Formgebung festgelegt werden. Lediglich die wegen des höheren Massegewichts vorzugsweise aus Metall bestehende Resonanzmassen und Balancemasse sind als separate Einzelteile in geeigneter Weise, beispielsweise durch Schnappverbindungen am Schwingarm bzw. Balancearm, zu befestigen. Es sind auch keine zusätzlichen Federelemente erforderlich, welche die zur Entstehung und Aufrechterhaltung der Schwingbewegungen benötigten Rückstellkräfte erbringen. Diese federnden Rückstellkräfte werden von dem oder den biegeelastischen Hebeln, nämlich dem Lenkerhebel und/oder dem Antriebshebel aufgebracht, wenn sie durch die Schwingbewegungen des Schwingarms im Rahmen ihrer Biegeelastizität biegend verformt werden.
Auch die für die lagensichere Aufnahme und Lagerung des Aktuators, der aus einem Piezo-Aktuator oder aus einem Schwingankermagneten minimaler Baugröße bestehen kann, erforderliche Einrichtung, kann aus einem einstückigen Kunststoffteil gefertigt sein, das vorzugsweise als Sockel eines das gesamte Schwingsystem lagestabil tragenden Gestells ausgebildet sein kann.

Während mit einem Schwingsystem gemäß Anspruch 1, das nur einen Schwingarm und nur einen Balancearm aufweist, nur ein Arbeitsorgan eines Arbeitsgerätes, beispielsweise die Membrane einer Luftpumpe, angetrieben werden kann, bietet eine andere auf dem gleichen Funktionsprinzip beruhende Ausführungsform der Erfindung die vorteilhafte Möglichkeit, zwei Arbeitsorgane oszillierend anzutreiben.

Diese Ausführungsform gemäß Anspruch 2 sieht vor, dass in symmetrischer Anordnung zu einer Symmetrieebene zwei Schwingarme vorgesehen sind, die jeweils an einem Paar von zwei ungleich langen Hebeln, nämlich einem Lenkerhebel und einem Antriebshebel, befestigt sind, wobei jeweils wenigstens einer dieser beiden Hebel, insbesondere der Lenkerhebel, wenigstens abschnittweise biegeelastisch ausgebildet ist und sein nicht mit einem Schwingarm verbundenes Ende an einer vom Schwingarm entfernten Stelle unbeweglich mit einem Gestellteil verbunden ist, in dem der Aktuator gelagert ist, und wobei der Antriebshebel mit dem Aktuator derart in bewegungsübertragender Verbindung steht, dass die Kraftimpulse des Aktuators den Schwingarmen zur Erzeugung ihrer Pendelschwingungen in einer Richtung zugeführt werden, die zumindest annähernd parallel zu deren Erstreckungsrichtung in der Ruhelage verläuft.

Besonders vorteilhaft dabei ist, dass die beiden jeweils mit einem Arbeitsorgan verbundenen Elemente des Schwingsystems, nämlich die beiden Balancearme, so gestaltet und angetrieben werden können, dass sie synchron schwingen. Es ist somit einfach, d.h. ohne besondere Maßnahmen möglich, gleichzeitig zwei Arbeitsorgane eines Arbeitsgerätes oder zweier Arbeitsgeräte synchron anzutreiben.
Als wichtiger Vorteil auch dieser Ausführungsform ist hervorzuheben, dass die wesentlichen Bestandteile auch dieses Doppelschwingsystems sich einstückig als ein einziges Kunststoffteil mit den geforderten Funktionseigenschaften durch entsprechende Formgebung und Kunststoffauswahl herstellen lassen. Das bedeutet, dass sich mit unwesentlichen Mehrkosten mit zwei gleichzeitig vom selben Aktuator angetriebenen Arbeitsorganen die doppelte Arbeitsleistung erzielen lässt.

Durch die Ausgestaltung der Erfindung nach Anspruch 3 können etwaige nachteilige Einflüsse der Schwerkraft auf das Schwingsystem vermieden werden.
Dabei ist es gleichgültig, ob das Schwingsystem aufrecht steht oder kopfüber aufgehängt ist oder ob die Anordnung so getroffen ist, dass die Schwingarme in Horizontallage horizontale Schwingbewegungen ausführen.

Durch die Ausgestaltung nach Anspruch 4 werden die möglichen Vorteile, die sich aus dem prinzipiellen Aufbau der Ansprüche 1 und 2 ergeben, realisiert.

Durch die Ausgestaltung nach Anspruch 5 ergibt sich ein sowohl bezüglich der Kraftübertragung bzw. Schwinungskonstanz gut beherrschbares Schwingsystem. Dabei ergibt sich durch die gegenläufigen synchronen Schwingbewegungen der Balancearme der funktionell wichtige Vorteil, dass eine Fluidpumpe mit zwei der gleichen Pumpenkammer zugeordneten Pumporganen, insbesondere Membranen, eingesetzt bzw. betrieben werden kann. Die Verwendung von Pumpenmembranen als Arbeitsorgane einer Fluidpumpe, insbesondere einer Luftpumpe, bietet sich deshalb in bekannter Weise an, weil Membranen den Antriebskräften kaum ins Gewicht fallende Widerstände entgegensetzen.

Durch die Ausgestaltung nach Anspruch 6 kann die Gegenläufigkeit der synchron schwingenden Schwingarme und Balancearme auf einfache Weise realisiert werden. Durch die weiteren Ausgestaltungen der Erfindung gemäß den Ansprüchen 7 und 8 können zumindest weitgehend koaxiale Bewegungen der die Verbindung zwischen den Balancearmen und den Arbeitsorganen herstellenden Kupplungsorgane erreicht werden.

Durch die Ausgestaltung nach Anspruch 9 ist es auf einfache Weise möglich, die oszillierenden Antriebsbewegungen synchron auf die beiden Schwingarme derart zu übertragen, dass diese jeweils synchrone, pendelartige Schwingbewegungen ausführen, ohne dass zusätzliche Mittel und Maßnahmen zur Erzielung der gewünschten Bewegungsrichtung erforderlich wären. Die dabei erzeugten Schwingbewegungen gleichen denjenigen eines Pendelstabes oder Stabpendels.

In den Ansprüchen 10 bis 30 sind unterschiedliche Ausführungsformen angegeben, die jeweils für sich oder in Kombination miteinander vorteilhaft realisiert werden können, um den jeweils gegebenen Erfordernissen entsprechende optimale Lösungen zu erhalten. Dabei ist die Ausführungsform gemäß Anspruch 23 insbesondere dann von Vorteil, wenn die Antriebsleistung eines einzelnen Piezo-Aktuators nicht ausreicht, um die geforderte Arbeitsleistung der angetriebenen Arbeitsorgane zu erreichen.

Hervorzuheben ist dabei auch die Ausgestaltung nach Anspruch 18, durch welche die Möglichkeit eröffnet wird, mit der eingesetzten Fluidpumpe nicht nur Luft sondern auch Flüssigkeiten pumpen zu können.

Anhand der nachfolgend aufgeführten Zeichnungsfiguren wird die Erfindung im Folgenden näher erläutert. Es zeigen:
- Fig. 1: einen elektrischen Schwingantrieb für eine Flu- idpumpe in isometrischer Darstellung;
- Fig. 2: den elektrischen Schwingantrieb der Fig. 1 in isometrischer Explosionsdarstellung;
- Fig. 3: den Schwingantrieb der Fig. 1 und 2 im Schnitt gemäß der Schnittlinie III-III aus Fig. 4;
- Fig. 3a: in vergrößerter Schnittdarstellung die Fluid- pumpe der Fig. 3;
- Fig. 4: einen Schnitt IV-IV aus Fig. 3;
- Fig. 5: in vergrößerter Schnittdarstellung die Fluid- pumpe der Fig. 3, jedoch mit federelastischen Kopplungselementen;
- Fig. 5a: einen Schnitt VIIIa - VIIIa aus Fig. 5.
- Fig. 6: eine mit zwei Aktuatoren ausgestatte Ausfüh- rungsform des Schwingantriebes in isometrischer Explosionsdarstellung;
- Fig. 7: in Schnittdarstellung gemäß der Schnittlinie VII - VII aus Fig. 8 eine andere Ausführungs- form des Schwingantriebs;
- Fig. 8: einen Schnitt VIII - VIII aus Fig. 7;
- Fig. 9: den Schwingantrieb gemäß Fig. 1 bis 4 in hän- gender Arbeitlage;
- Fig. 10: den Schwingantrieb gemäß Fig. 1 bis 4 in hori- zontaler Arbeitslage;
- Fig.11 bis 23: jeweils schematische Darstellungen weiterer un- terschiedlicher Ausführungsformen eines Schwingantriebs.

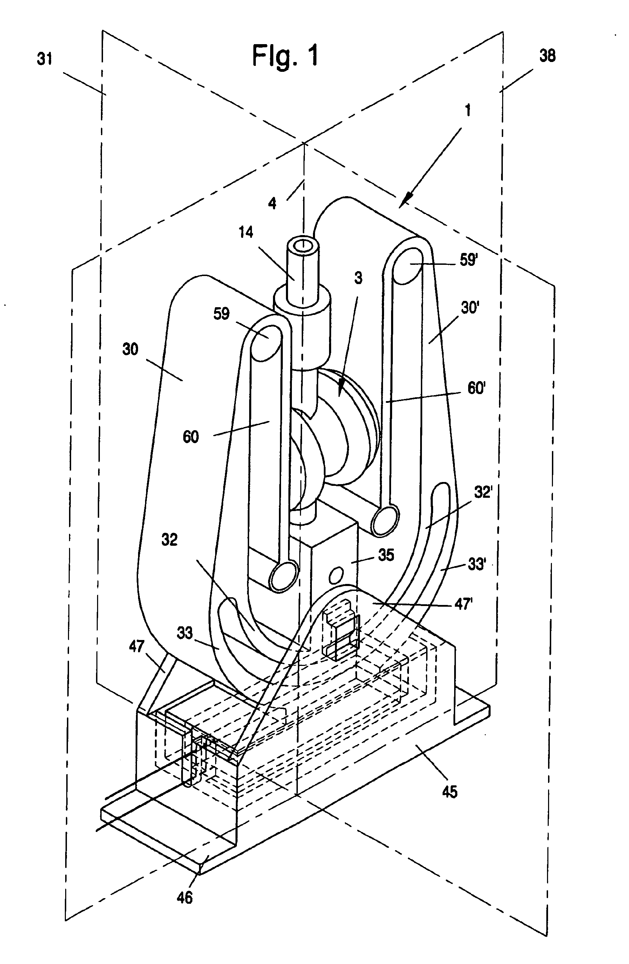

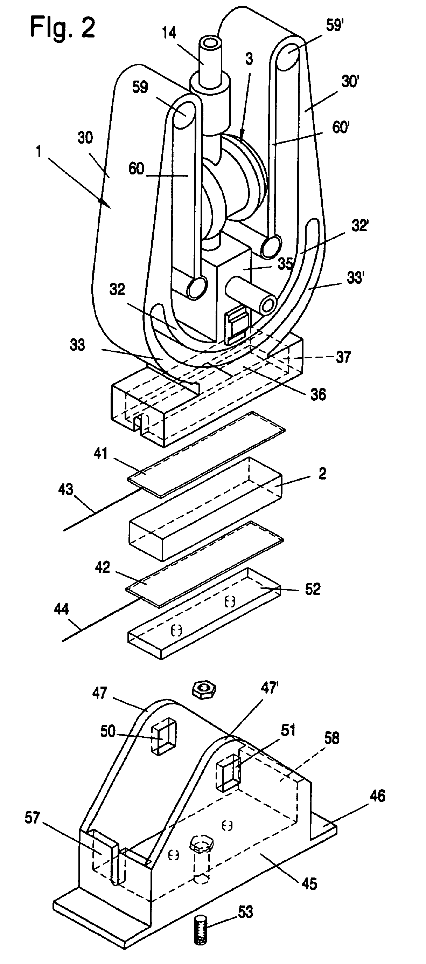

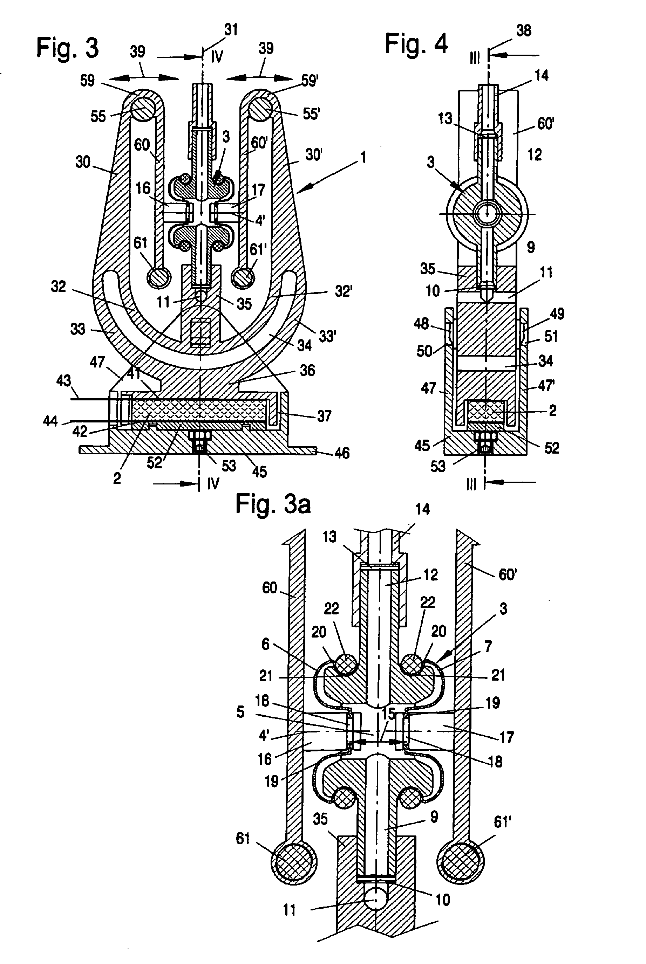

In den Fig. 1 bis 4 ist ein funktionsfähiges Ausführungsbeispiel eines elektrischen Schwingantriebes dargestellt, bei dem ein Schwingsystem 1 von einem Piezo-Aktuator 2 (Fig. 2) zur Betätigung einer Fluidpumpe 3 vorgesehen ist. Bei der Fluidpumpe 3 handelt es sich um eine Membranpumpe, die als Arbeitsorgane bzw. Pumporgane zwei symmetrisch zu einer vertikalen Mittelachse 4 (Fig. 1) und mit einer gemeinsamen horizontalen Achse 4' koaxial zueinander angeordnete, einer gemeinsamen Pumpenkammer 5 (Fig. 3 und Fig. 3a) zugeordnete Pumpenmembranen 6 und 7 aufweist. Diese Pumpenmembranen 6 und 7 sind auf den beiden sich gegenüberliegenden Seiten eines Pumpenkörpers 8 selbsthaltend angebracht. In diesem Pumpenkörper 8 befindet sich die Pumpenkammer 5, die über einen Ansaugkanal 9 und ein Ansaugventil 10 mit einer Ansaugbohrung 11 in Verbindung steht. Druckseitig ist die Pumpenkammer 5 über einen Auslasskanal 12 und ein Auslassventil 13 mit einer Anschlusshülse 14 verbunden. An diese Anschlusshülse 14 kann über eine Schlauchverbindung jedes beliebige mit Druckluft zu betreibende Gerät angeschlossen werden.

Um die Pumpenkammer 5 periodisch zu verkleinern und zu vergrößern, ist es erforderlich, die beiden Pumpenmembranen 6 und 7 zueinander synchron gegenläufig und koaxial zu bewegen. Diese Bewegungen sind durch den Doppelpfeil 15 (Fig. 3a) angedeutet. Zu diesem Zweck sind die beiden Pumpenmembranen 6 und 7 jeweils mit zentralen Kopplungselementen 16 und 17 formschlüssig verbunden, die diese Bewegungen ausführen und die jeweils Teil des Schwingsystems 1 sind. Bei dem Ausführungsbeispiel der Fig. 3 und 3a bestehen diese beiden Kopplungselemente 16 und 17 jeweils aus zylindrischen Bolzen, die an den ihnen einander zugekehrten Endabschnitten jeweils Ringnuten 18 aufweisen, in welche verstärkte Randabschnitte 19 einer zentralen kreisrunden Öffnung, die jede Pumpenmembrane 6, 7 aufweist, formschlüssig und unter radialer Spannung eingelegt sind.

Die äußeren, im Profil etwa halbkreisförmig ausgebildeten Endabschnitte 20 der beiden Pumpenmembranen 6 und 7, liegen in entsprechend halbkreisförmig profilierten Ringnuten 21 des Pumpenkörpers 8 und sind durch Federringe 22 jeweils gesichert.

Die beiden Kopplungselemente 16 und 17 können, wenn die Fluidpumpe 3 nur zum Pumpen von Luft oder anderen kompressiblen Gasen verwendet wird, als starre, massive Bolzen ausgebildet sein.

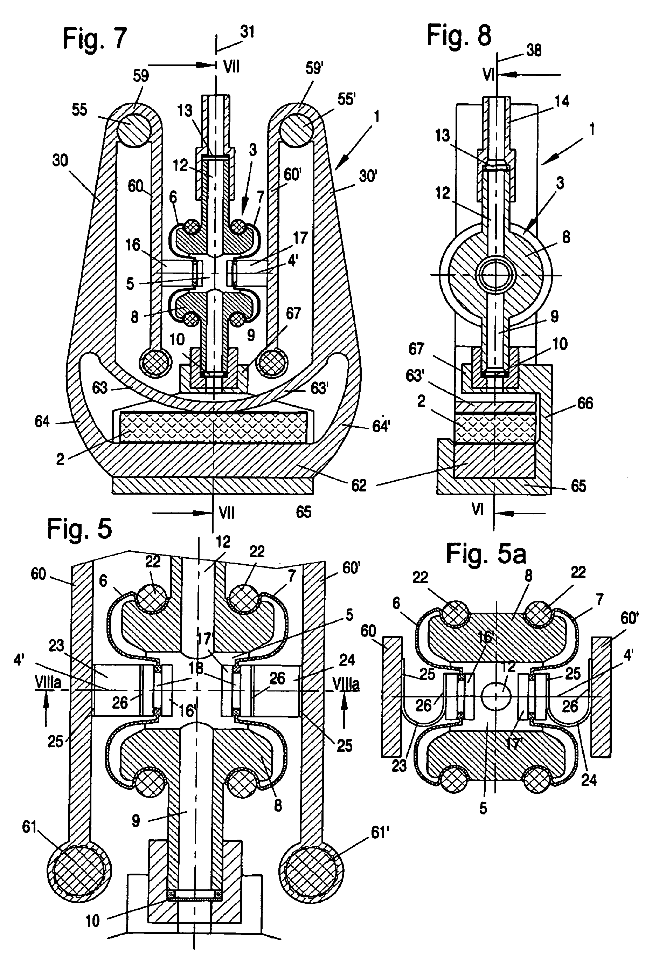

Wenn die Fluidpumpe 3 jedoch zum Pumpen von nicht kompressiblen Flüssigkeiten verwendet wird, ist es empfehlenswert, Kopplungselemente zwischen den Membranen 6, 7 und den schwingenden Antriebsgliedern des Schwingsystems 1 zu verwenden, die in Schubrichtung elastisch sind. Ein Ausführungsbeispiel solcher elastischer Kopplungselemente ist in den Fig. 5 und 5a dargestellt. Dabei handelt es sich jeweils um U-förmig gebogene Blattfedern 23 bzw. 24, von denen jeweils ein Schenkel 25 mit dem Schwingsystem 1 in Verbindung steht, während der andere Schenkel 26 jeweils mit einem Kopplungselement 16' bzw. 17' verbunden ist, das die bereits erwähnte Ringnut 18 aufweist, in welcher der Lochrand 19 der Pumpenmembrane 6 bzw. 7 formschlüssig aufgenommen ist.

Es sind selbstverständlich auch andere Formen elastischer Kopplungselemente denkbar, z. B. federnd gelagerte Bolzen od. dgl.

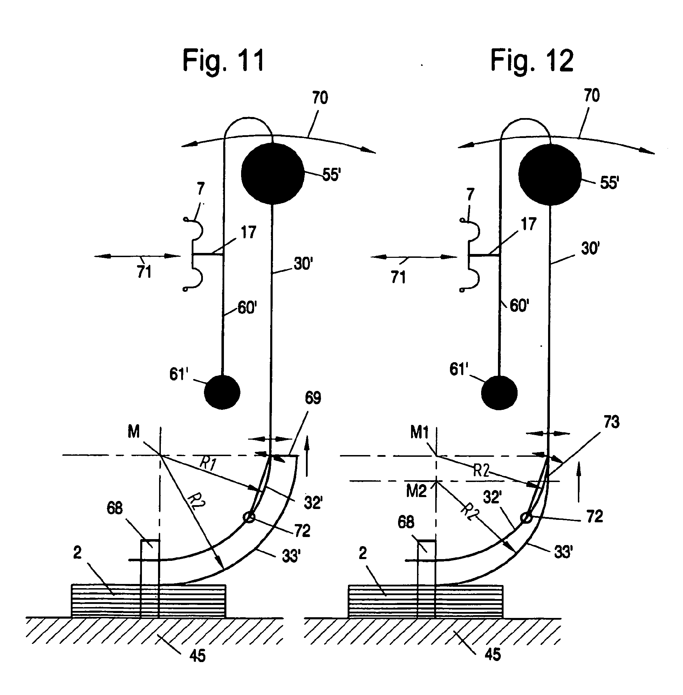

Wie den Fig. 1 bis 4 zu entnehmen ist, besteht das Schwingsystem 1 in einer bevorzugten Ausführungsform aus zwei Schwingarmen 30 und 30', die symmetrisch zu einer vertikalen, in der Mittelachse 4 der Fluidpumpe 3 liegende Symmetrieebene 31 angeordnet sind und im Wesentlichen parallel zu dieser verlaufen. Die unteren Enden der Schwingarme 30 und 30' sind jeweils mit zwei ungleich langen Hebeln, nämlich einem Lenkerhebel 32 bzw. 32' und einem Antriebshebel 33 bzw. 33' einstückig verbunden, die ebenso wie die Schwingarme 30 und 30' aus einem formstabilen, jedoch zumindest schwach biegeelastischen Kunststoff bestehen.
Wie aus den zeichnerischen Darstellungen, insbesondere aus Fig. 3, ersichtlich ist, sind die beiden Lenkerhebel 32, 32' im Bereich der Symmetrieebene 31 einstückig miteinander verbunden und so geformt, dass sie gemeinsam einen Halbkreis bilden, dessen Enden mit den beiden Schwingarmen 30 bzw. 30' verbunden sind. Auch die beiden Antriebsarme 33 und 33' bilden zusammen einen Halbkreis, dessen Enden mit den beiden Schwingarmen 30, 30' verbunden sind. Die ungleiche Länge der Lenkerarme 32, 32' einerseits und der Antriebsarme 33, 33' andererseits ergibt sich bei dieser Geometrie aus den unterschiedlichen Radien **R1** und **R2,** die in den Fig. 11, 13 und 14 eingezeichnet sind. Wie aus den Fig. 1 bis 3 ersichtlich ist, besteht zwischen den jeweils einen Halbkreis bildenden Lenkerarmen 32, 32' einerseits und den Antriebsarmen 33, 33' andererseits eine durchgehende Nut 34, welche die beiden halbkreisförmigen Hebel voneinander trennt. Die Querschnittsformen der Lenkerhebel 32, 32' und der Antriebshebel 33, 33' sind jeweils rechteckig, d.h., sie sind jeweils bandartig ausgebildet. Durch entsprechende Auswahl des verwendeten Kunststoffes und durch die Querschnittsform bzw. durch die jeweilige Dicke, welche die Lenkerhebel 32, 32' und 33, 33' aufweisen, ist gewährleistet, dass sowohl die Lenkerhebel 32, 32' als auch die Antriebshebel 33, 33' eine gewisse Biegeelastizität aufweisen, die eine pendelartige Schwingbewegung der beiden Schwingarme 30 und 30' ermöglicht. Dabei sollen die Schwingbewegungen der Schwingarme möglichst genau denen eines Stabpendels gleichen.

Während innerhalb des von den beiden Lenkerhebeln 32, 32' gebildeten Halbkreises ein einstückig mit diesen verbundenes Stützteil 35 symmetrisch zur Symmetrieebene 31 angeordnet ist, sind die beiden Antriebshebel 33 und 33' auf der Außenseite des von ihnen gebildeten Halbkreises mit einem nach unten gerichteten Fußteil 36 versehen, das als quaderförmiger Hohlkörper ausgebildet ist. Dieses Fußteil 36 weist einen Hohlraum 37 auf, in dem der beispielsweise quaderförmige, vorzugsweise mehrschichtige Piezo-Aktuator 2 untergebracht ist. Dieser Piezo-Aktuator 2 ist ober- und unterseitig jeweils mit Kontaktplatten 41 und 42 (Fig. 2) versehen, über welche er mit Hilfe von Anschlussleitungen 43, 44 an eine Wechselstromquelle angeschlossen werden kann. Um im Bereich der Symmetrieebene 31 zwischen den Lenkerarmen 32, 32' einerseits und dem Piezo-Aktuator 2 andererseits eine feste Verbindung herstellen zu können, ist ein Gestellteil 45 vorgesehen. Dieses Gestellteil 45 ist mit zwei parallelen, nach oben gerichteten Seitenwänden 47 und 47' versehen, welche das Fußteil 36 des Schwingsystems 1 bzw. der beiden Antriebshebel 33 und 33' sowie den in dessen Hohlraum 37 untergebrachten Piezo-Aktuator 2 mit seinen beiden Kontaktplatten 41 und 42 zwischen sich aufnehmen. Durch die Seitenwände 47 und 47' dieses Gestellteils 45 wird eine stabile Verbindung zwischen dem Piezo-Aktuator 2 und den beiden Lenkerhebeln 32, 32' dadurch geschaffen, dass das Stützteil 35 beidseitig mit Rastnocken 48 bzw. 49 (Fig. 4) versehen ist, die formschlüssig in dazu passende Ausnehmungen 50, 51 eingreifen, wie das beispielsweise in Fig. 4 dargestellt ist. Auf diese Weise sind die nicht mit einem Schwingarm 30 bzw. 30' verbundenen Enden der beiden Lenkerhebel 32, 32' an einer vom Schwingarm 30, 30' entfernten Stelle unbeweglich mit dem Gestellteil 45 verbunden.

Für eine einwandfreie Funktionsweise des Schwingsystems 1 ist es erforderlich, dass die beiden Antriebshebel 33, 33' mit ihrem Fußteil 36 unter einer gewissen Federspannung auf dem Piezo-Aktuator 2 aufliegen, so dass dessen im Rhythmus der angelegten Wechselspannung auftretenden Antriebsimpulse spielfrei und somit verlustfrei auf die Antriebshebel 33, 33' und über diese auf die Schwingarme 30 bzw. 30' übertragen werden und diese Schwingarme 30, 30' jeweils pendelartige Schwingbewegungen ausführen. Dabei erfolgt die Übertragung der Antriebsimpulse des Piezo-Aktuators 2 in einer Richtung, die parallel verläuft zur Erstreckungsrichtung der Schwingarme 30 bzw. 30' in deren Ruhelage. Durch die Anordnung und Wirkungsweise der beiden Lenkerarme 32 und 32' ergeben sich dabei die erwünschten pendelartigen Schwingbewegungen der Schwingarme 30 und 30', die an ihren oberen Enden jeweils mit Resonanzmassen 55 und 55' versehen sind. Diese Resonanzmassen 55 und 55' sind so gewählt, dass die beiden Schwingarme 30, 30' jeweils Eigenschwingungen aufweisen, deren Frequenz mit der Frequenz der am Piezo-Aktuator 2 angelegten Wechselspannung übereinstimmt.

Für eine leistungsfähige Funktionsweise ist dieser Synchronismus zwischen den Antriebsimpulsen des Piezo-Aktuators 2 und der Eigenfrequenz der Schwingarme 30, 30' von Bedeutung. Eine weitere Voraussetzung ist, dass die beiden Schwingarme 30, 30' miteinander synchron schwingen und dass ihre Schwingbewegungen in der gleichen Ebene 38 erfolgen. Für den Betrieb der oben beschriebenen Fluidpumpe 3 ist es auch wichtig, dass die Schwingarme 30, 30' ihre synchronen Schwingbewegungen gegenläufig ausführen, so dass sich auch die Arbeitsorgane, d. h. die beiden Pumpenmembranen 6 und 7 jeweils synchron gegenläufig zueinander bewegen, um die doppelte Pumpleistung zu erbringen.

Eine weitere Voraussetzung für ein effektives, störungsfreies Funktionieren des Schwingantriebs besteht darin, dass die beiden Arbeitsorgane, d. h. die beiden Pumpenmembranen 6 und 7 durch koaxial zueinander erfolgende Antriebsbewegungen betätigt werden. Das bedeutet, dass die Kopplungselemente 16 und 17 bzw. 16' und 17' (Fig. 8 und 8a) jeweils zumindest annähernd koaxial zueinander bewegt werden. Dies wird dadurch erreicht, dass die Kopplungselemente 16, 17 bzw. die Blattfedern 23 und 24 jeweils an Balancearmen 60 und 60' befestigt sind. Diese Balancearme 60, 60' sind etwa gleich lang wie die Schwingarme 30, 31 und sie erstrecken sich jeweils parallel zu den Schwingarmen 30, 30'. Sie sind zwischen den Schwingarmen 30, 30' symmetrisch zu der Symmetrieebene 31 parallel zu dieser angeordnet und jeweils über biegeelastische Verbindungsbogen 59 bzw. 59' mit dem jeweils zugehörigen Schwingarm 30, 30' verbunden. An ihren unteren Enden sind die Balancearme 60 und 60' jeweils mit Balancemassen 61, 61' versehen, die so gewählt sind, dass die Balancearme 60 und 60' jeweils im Rhythmus der Schwingarme 30, 30' oszillierende Bewegungen parallel zu sich selbst ausführen, so dass die mit ihnen über die Kopplungselemente 16, 17 bzw. 23, 24 verbundenen Pumpmembranen 6 und 7 keinen schädlichen Kippbewegungen ausgesetzt sind.

Die pendelartigen Schwingbewegungen der beiden Schwingarme 30 und 30' verlaufen in der zur Symmetrieebene 31 rechtwinkligen Schwingebene 38 (Fig. 1) in Richtung der Doppelpfeile 39 und 39'. Damit die Schwingarme 30 und 30' sowie die Balancearme 60 und 60' zwangsläufig in einer vorgegebenen Ebene, nämlich der Ebene 38 schwingen und somit kontrollierte Arbeitsbewegungen ausführen, können verschiedene Maßnahmen angewandt werden. Bei den bevorzugten Ausführungsbeispielen sind sowohl die Schwingarme 30, 30' als auch die Balancearme 60, 60' und die mit den Schwingarmen 30 und 30' in direkter Verbindung stehenden Lenkerhebel 32, 32' sowie die Antriebshebel 33 und 33' jeweils mit rechteckigen Querschnittsformen versehen, d. h. sie sind zumindest annähernd bandartig bzw. blattfederartig ausgebildet. Eine andere naheliegende Möglichkeit besteht darin, jeweils zwei oder mehr parallel nebeneinander und zumindest abschnittsweise miteinander verbundene Stäbe zu verwenden, die so gebogen sind, dass sie in Seitenansicht etwa die gleiche Form ergeben wie die Ausführungsbeispiele.

Die Gegenläufigkeit dieser Schwingbewegungen der beiden Schwingarme 30 und 30' wird dadurch erreicht, dass die Verbindungen zwischen den Schwingarmen 30, 30' und den Lenkerhebeln 32, 32' sowie den Antriebshebeln 33 und 33' jeweils spiegelbildlich bzw. symmetrisch zur Symmetrieebene 31 angeordnet sind. D. h. die Verbindungen zwischen den Lenkerhebeln 32, 32' und den Schwingarmen 30, 30' liegen beispielsweise innerhalb der Verbindungen, welche den Antriebshebel 33, 33' mit den Schwingarmen 30, 30' verbinden.

Damit die für eine einwandfreie leistungsstarke Funktionsweise erforderliche, federelastische Vorspannung zwischen dem Fußteil 36 und dem Piezo-Aktuator 2 trotz der nicht zu vermeidenden Fertigungstoleranzen sicher erreicht bzw. eingestellt werden kann, liegt der Piezo-Aktuator 2 mit seiner Unterseite auf einer Justierplatte 52 auf, die mittels einer Justierschraube 53 in vertikaler Richtung relativ zum Gestellteil 45 und somit auch relativ zu den beiden Lenkerhebeln 32, 32' verstellt werden kann.

Durch quer verlaufende Stirnwände 57, 58 ist zwischen den Seitenwänden 47 und 47' ein auch stirnseitig geschlossener, oberseitig offener Hohlraum 54 gebildet, in dem das Fußteil 36 mit dem Piezo-Aktuator 2 lagefixiert aufgenommen ist.

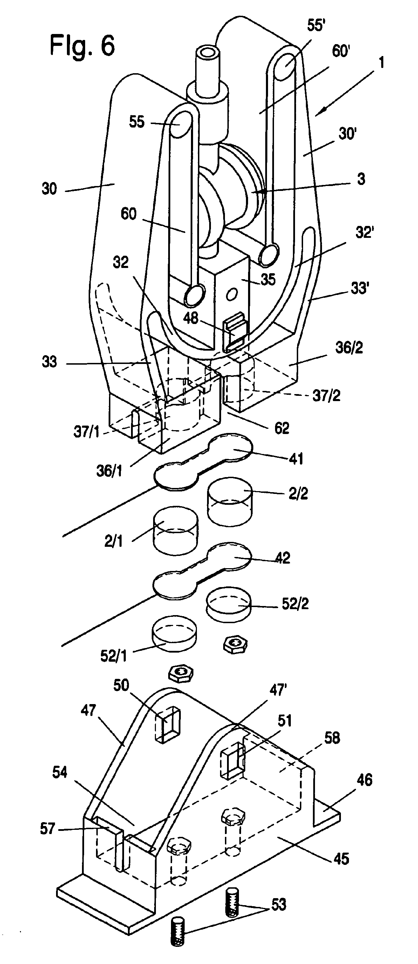

Die in Fig. 6 in Explosionsdarstellung wiedergegebene Ausführungsform unterscheidet sich von derjenigen der Fig. 1 bis 4 nur dadurch, dass das Fußteil in der Mitte durch einen Schlitz 62 unterbrochen und somit geteilt ist. Die dadurch entstandenen separaten Fußteile 36/1 und 36/2 sind über nicht miteinander verbundene Antriebshebel 33/1 und 33/2 je für sich mit den beiden Schwingarmen 30 und 30' verbunden. In diesen beiden Fußteilen 36/1 und 36/2 sind jeweils separate, beispielsweise zylinderförmig ausgebildete, Piezo-Aktuatoren 2/1 bzw. 2/2 in entsprechenden zylindrischen Hohlräumen 37/1 und 37/2 untergebracht. Diese Piezo-Aktuatoren 2/1, 2/2 können jedoch durch gemeinsame Kontaktplatten 41 und 42 mit der gleichen Spannungsquelle betrieben werden. Im Übrigen ist die Funktionsweise die gleiche wie bei den Ausführungsformen der Fig. 1 bis 4. Es sind auch zwei Justierplatten 52/1 und 52/2 sowie zwei Justierschrauben 53 vorgesehen.

In den Fig. 7 und 8 ist eine weitere Ausführungsform mit einem Schwingsystem 1' dargestellt, bei der die Schwingarme 30 und 30', die Balancearme 60 und 60' sowie die Fluidpumpe 3 in der gleichen Form und Anordnung vorhanden sind wie bei den Ausführungsbeispielen der Fig. 1 bis 5. Bei dieser Ausführungsform der Fig. 7 und 8 ist jedoch der Piezo-Aktuator 2 zwischen einem Fußteil 62 und zwei biegeelastischen Lenkerhebeln 63 und 63' angeordnet und das Fußteil 62 einstückig über biegeelastische Lenkerhebel 64 bzw. 64' mit jeweils einem der Schwingarme 30 bzw. 30' verbunden. Die beiden Antriebshebel 63 und 63' befinden sich bei dieser Ausführungsform zwischen den beiden Lenkerhebeln 64 und 64', die ihrerseits seitlich an dem Fußteil 62 einstückig angeformt sind und ebenfalls flache bandartige Querschnitte aufweisen. Dabei liegt der Piezo-Aktuator 2 unmittelbar auf der ebenen oberen Fläche 65 des Fußteils 62 auf und zwar unter dem federnden Anpressdruck der beiden im Bereich der Symmetrieebene 31 miteinander verbundenen, ebenfalls flachbandartig ausgebildeten Antriebshebel 63 bzw. 63', die oberseitig auf dem Piezo-Aktuator 2 aufliegen. Aber auch bei dieser Anordnung besteht die Möglichkeit, zwischen dem Fußteil 62 und dem Piezo-Aktuator 2 eine Justierplatte anzuordnen.

Gegenüber der Ausführungsform der Fig. 1 bis 5 sind bei dieser Ausführungsform gemäß Fig. 7 und 8 die Antriebshebel 63, 63' und die Lenkerhebel 64, 64' sowohl bezüglich ihrer Anordnung als auch bezüglich ihrer Funktion vertauscht. Die Funktionsweise der Schwingarme 30 und 30' und der mit ihnen verbundenen Balancearme 60 und 60' ist jedoch die gleiche.

Um die Fluidpumpe 3 lagefixierend mit dem Fußteil 62 des Schwingsystems 1' stabil verbinden zu können, ist ein Sockelteil 65 vorgesehen, welches das Fußteil 62 umschließend aufnimmt. Dieses Sockelteil 65 ist seitlich mit einem Wandelement 66 versehen, das auf der konkaven Seite des von den beiden Antriebshebeln 63, 63' gebildeten Bogens einen Trägerarm 67 aufweist, der die Fluidpumpe 3 tragend aufnimmt.
Mit dieser Ausführungsform soll angedeutet werden, dass es weitere Möglichkeiten gibt, das Funktionsprinzip des erfindungsgemäßen Schwingantriebes zu realisieren. Einige dieser Möglichkeiten sollen nun anhand der Fig. 11 bis 23 erläutert werden.

Während beim Ausführungsbeispiel der Fig. 1 bis 8 jeweils zwei Schwingarme mit den zugehörigen Lenkerhebeln 32, 32'und Antriebshebeln 33, 33' sowie Balancearmen 60, 60' zur Betätigung zweier Arbeitsorgane in Form von Pumpenmembranen 6, 7 vorgesehen sind, besteht selbstverständlich auch die Möglichkeit, dasselbe Aufbau- und Funktionsprinzip mit nur einem Schwingarm 30 durchzuführen, wie es schematisch in den Fig. 11 und 12 dargestellt ist.

In Fig. 11 ist der Schwingarm 30' einerseits mit einem kreisbogenförmigen Lenkerarm 32' und mit einem dazu konzentrisch verlaufenden Antriebsarm 33' verbunden. Der Lenkerarm 32' hat einen Radius R1, der kleiner ist als der Radius R2 des ebenfalls kreisbogenförmigen Antriebshebels 33'. Beide Hebel 32' und 33' haben den gleichen Krümmungsmittelpunkt M. Das untere Ende des Lenkerhebels 32' ist ortsfest an einer vom Schwingarm 30' entfernten Stelle unbeweglich und somit in einem definierten Abstand vom Piezo-Aktuator 2 mit einem Gestellteil 68 verbunden. Mit diesem Gestellteil 68 unbeweglich verbunden ist auch der Piezo-Aktuator 2. Das untere Ende des Antriebshebels 33' liegt federnd und bewegungsübertragend auf der Oberseite des Piezo-Aktuators 2 auf, während sein oberes Ende über einen kurzen Verbindungshebel 69 mit dem unteren Ende des Schwingarms 30' und somit zugleich mit dem oberen Ende des Lenkerarms 32' verbunden ist. Durch die vertikalen Antriebsbewegungen des Piezo-Aktuators 2 wird der am biegeelastischen Lenkerarm 32' angelenkte Schwingarm 30' zur Ausführung von pendelartigen Schwingbewegungen in Richtung des Doppelpfeiles 70 angeregt. Der parallel zu sich selbst mitschwingende Balancearm 60' betätigt dabei über das Verbindungsglied 17 die Pumpenmembrane 7 in Richtung des Doppelpfeiles 71.

Durch die Biegeelastizität des Lenkerhebels 32' entsteht eine Schwingbewegung des oberen Endes des Lenkerhebels 32', die zumindest annähernd um einen angenommenen Drehpunkt 72 erfolgt.

Etwa die gleichen Bewegungen können auch mit der Ausführungsform gemäß Fig. 12 erreicht werden. Bei dieser Ausführungsform haben der Lenkerhebel 32' und der Antriebshebel 33' jeweils den gleichen Krümmungsradius R1, jedoch sind ihre Mittelpunkte M1 und M2 um das Maß E in vertikaler Richtung in der Symmetrieebene 31 zueinander versetzt. Weil dabei die von den Hebeln 32' und 33' gebildeten Bogen die gleiche Länge aufweisen, ist es erforderlich, das obere Ende des Antriebshebels 33' mit einer Verlängerung 73 zu versehen, über welche er mit dem oberen Ende des Lenkerhebels 32' und zugleich mit dem unteren Ende des Schwingarms 30' verbunden ist. Der Lenkerhebel 32' und der Antriebshebel 33' sind somit wieder ungleich lang. Auch hierbei werden die in Richtung des Pfeiles 74, also in Erstreckungsrichtung des Schwingarmes 30' erfolgenden Antriebsbewegungen in quer dazu verlaufende Schwingbewegungen des Schwingarmes 30' umgewandelt, so dass der Schwingarm 30' die angestrebten pendelartigen Schwingungen in Richtung des Doppelpfeiles 70 ausführt und dabei über den Balancearm 60' die Membrane 7 in oszillierende Bewegungen in Richtung des Doppelpfeiles 71 versetzt.

Wie aus den Fig. 11 und 12 ohne Weiteres erkennbar ist, sind hier auch die Bedingungen der vorteilhaften Hebelübersetzungen erfüllt, indem einerseits die Lenkerhebel 32' und die Antriebshebel 33' ungleich lang sind und andererseits der Schwingarm 30' jeweils länger ist als der wirksame Hebelarm, an dem die Kraftimpulse vom Piezo-Aktuator 2 auf den Schwingarm 30' übertragen werden.

Dies gilt auch für alle bereits beschriebenen und im Folgenden noch zu beschreibenden Ausführungsformen.

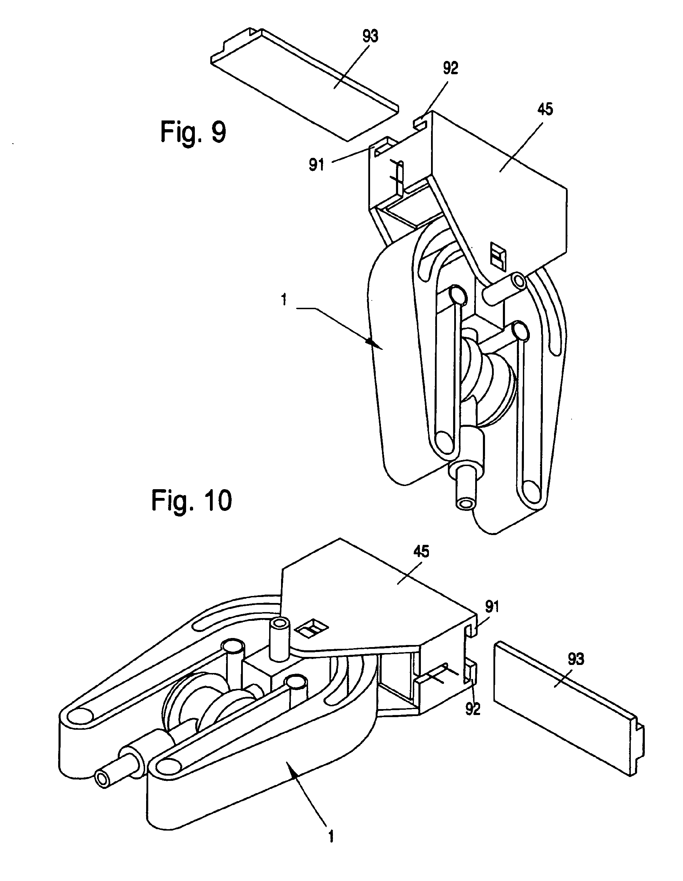

In diesem Zusammenhang ist auch darauf hinzuweisen, dass alle Ausführungsformen dieser Erfindung nicht nur in aufrechter Lage, wie sie in den Fig. 1 bis 8 und den Fig. 11 bis 23 dargestellt sind, betrieben werden können, sondern auch in hängender Arbeitslage, die in der Fig. 9 dargestellt ist und in liegender, d. h. in horizontaler Arbeitslage, wie in Fig. 10 dargestellt. In diesen drei Arbeitslagen hat die Schwerkraft keinen nachteiligen bzw. störenden Einfluss auf die Arbeitsweise des Schwingsystems 1 bzw. 1'.

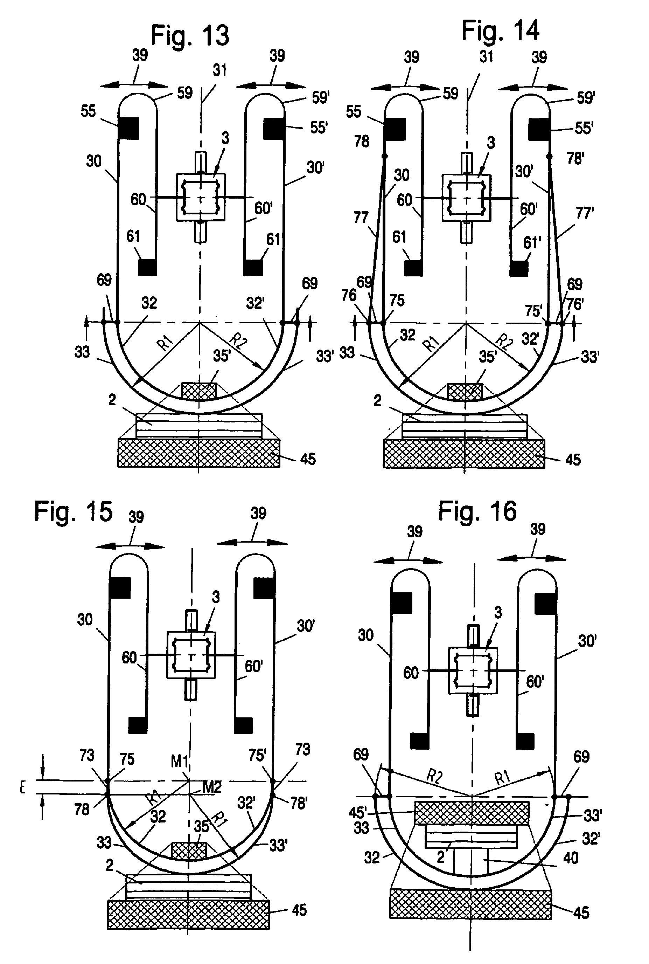

Bei der Fig. 13 handelt es sich um die schematische Darstellung des Aufbaus und der Wirkungsweise des in den Fig. 1 bis 4 bzw. 6 dargestellten Schwingsystems 1.

Bei allen Ausführungsformen bestehen die Schwingarme 30, 30', deren Balancearme 60, 60' sowie die Lenkerhebel 32, 32' und die Antriebshebel 33, 33' jeweils aus formstabilem Kunststoff. Die jeweils einem Schwingarm 30, 30' zugeordneten Balancearme 60, 60', Lenkerhebel 32, 32' und Antriebshebel 33, 33' sind jeweils über biegeelastische Verbindungsabschnitte einstückig mit diesem verbunden. Die Balancearme 60, 60' bestehen jeweils aus formstabilem, allenfalls schwach biegeelastischem Kunststoff. Die pendelartigen Schwingbewegungen der beiden sich beiderseits der Symmetrieebene 31 symmetrisch gegenüberstehenden Schwingarme 30, 30' und deren Balancearme 60, 60' verlaufen gegenläufig synchron.

Wie schon erwähnt sind die Verbindungen zwischen den Schwingarmen 30, 30' und den Lenkerhebeln 32, 32' sowie den Antriebshebeln 33, 33' auf beiden Seiten der Symmetrieebene 31 jeweils spiegelbildlich zueinander angeordnet. D. h., wenn beispielsweise bei der Ausführungsform der Fig. 1 bis 3 die Verbindung zwischen dem Antriebshebel 33 und dem Schwingarm 30 außerhalb der Verbindung des Lenkerhebels 32 mit dem Schwingarm 30 liegt, so liegt auf der anderen Seite der Symmetrieebene 31 auch die Verbindung zwischen dem Antriebshebel 33' und dem Schwingarm 30' außerhalb der Verbindung des Lenkerarms 32' mit dem Schwingarm 30'. Bei der Ausführungsform der Fig. 7 jedoch liegen die Verbindungen zwischen den Lenkerhebeln 64, 64' mit den beiden Schwingarmen 30, 30' jeweils außerhalb der Verbindungen der Antriebshebel 63 und 63' mit diesen Lenkerhebeln 30 bzw. 30'. Aber auch hier ist die spiegelbildliche Anordnung dieser Verbindungen gewährleistet. Diese ist nämlich Voraussetzung dafür, dass die Schwingarme 30 und 30' mit ihren Balancearmen 60 und 60' jeweils zueinander gegenläufig synchron schwingend angetrieben werden.

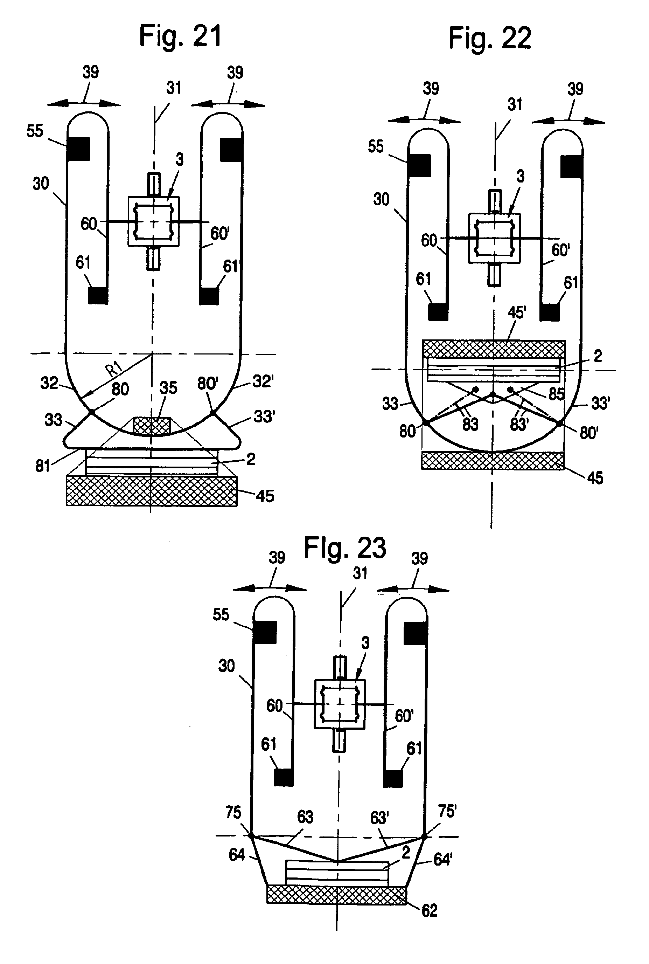

Der Ausführungsform der Fig. 7, 8 entspricht die schematische Darstellung der Fig. 23. Zu dieser Fig. 23 ist ergänzend zu erwähnen, dass die beiden dort dargestellten Antriebshebel 63 und 63' gemeinsam einen Kreisbogen bilden können, wie in Fig. 7 dargestellt. Andererseits ist es aber auch möglich, die beiden Antriebshebel 63 und 63' jeweils als gerade, nicht biegsame Flachstäbe auszubilden, die im Bereich ihrer Auflage auf dem Piezo-Aktuator 2, d. h. im Bereich der Symmetrieebene 31, gelenkig oder biegeelastisch miteinander verbunden sind. Ihr federndes Aufliegen auf dem Piezo-Aktuator 2 wird durch Federelastizität der beiden Lenkerarme 64, 64' bewirkt.

Die schematische Darstellung der Fig. 14 entspricht ziemlich exakt den Ausführungsformen der Fig. 1 bis 3. Auch hier bilden die beiden bogenförmig verlaufenden und miteinander verbundenen Lenkerhebel 32, 32' sowie die Antriebshebel 33 und 33' jeweils zueinander konzentrische Halbkreise mit den unterschiedlichen Radien R1 und R2 und dem gleichen Krümmungsmittelpunkt M. Zwischen den Verbindungspunkten 75 bzw. 75', durch welche die Enden der Lenkerhebel 32 bzw. 32' mit den Schwingarmen 30, 30' verbunden sind, und den Verbindungspunkten 76 bzw. 76', an denen die Antriebshebel 33 bzw. 33' mit stabförmigen Verlängerungen 77 bzw. 77' verbunden sind, bestehen jeweils Hebelarme 69, die auch bei der Ausführungsform der Fig. 11 vorhanden sind. Die Verlängerungen 77, 77' sind jeweils im oberen Endbereich an den Verbindungsstellen 78 bzw. 78' mit den Schwingarmen 30 bzw. 30' starr verbunden.

Während die Halbkreisbogen der beiden Antriebshebel 33 und 33' jeweils im Bereich der Symmetrieebene 31 mittig auf dem Piezo-Aktuator 2 bewegungsübertragend aufliegen und von diesem betätigt werden, ist auf der konkaven Innenseite des von den beiden Lenkerhebeln 32, 32' gebildeten Kreisbogens das dem Stützteil 35 entsprechende Gegenlager 35' angeordnet. Dieses Gegenlager 35' ist fest mit dem Gestellteil 45 verbunden. Durch den definierten Abstand dieses Gegenlagers 35' vom Piezo-Aktuator 2 wird die von der Biegeelastizität der Lenkerhebel 32, 32' erzeugte federnde Andruckspannung zwischen den Antriebshebeln 33, 33' und dem Piezo-Aktuator 2 aufrechterhalten bzw. bestimmt.

Wie in Fig. 11 sind auch bei der Ausführungsform der Fig. 15 die beiden einerseits von den Lenkerhebeln 32, 32' und andererseits von den Antriebshebeln 33, 33' gebildeten Halbkreise jeweils mit den gleichen Radien R1 versehen. Die Krümmungsmittelpunkte M1 und M2 sind jedoch in der Symmetrieebene 31 um das Maß E gegeneinander versetzt. Wie bei der Ausführungsform der Fig. 14 sind die Enden der Lenkerhebel 32 und 32' an den Verbindungspunkten 75 und 75' mit den Lenkerhebeln 30 und 30' verbunden. Zwischen den Enden der Antriebshebel 33 und 33' und den Verbindungspunkten 75 bzw. 75' sind jeweils gerade verlängernde Verbindungsstücke 73 vorgesehen, über welche an den Verbindungspunkten 75 bzw. 75' die Verbindungen der Schwingarme 30 und 30'mit den Antriebshebeln 33 bzw. 33' hergestellt sind. Auch bei dieser Ausführungsform entstehen durch die vom Piezo-Aktuator 2 über die Antriebshebel 33, 33' auf die Schwingarme 30 bzw. 30' übertragenen periodischen Kraftimpulse die pendelartigen Schwingbewegungen der Schwingarme 30 und 30' in der beschriebenen Weise.

Die Anordnung und die Funktionsweise des Ausführungsbeispiels der Fig. 15 entsprechen somit, auf jeweils eine Hälfte rechts bzw. links der Symmetrieebene 31 bezogen, derjenigen der Fig. 12.

In der Fig. 16 ist schematisch eine Ausführungsform dargestellt, bei der die zum Schwingsystem 1 gehörenden Bestandteile, nämlich die Schwingarme 30, 30', die Balancearme 60, 60', die Lenkerhebel 32, 32' und die Antriebshebel 33, 33' gleich ausgebildet und angeordnet sind wie bei der Ausführungsform der Fig. 13. Der Unterschied zu dieser Ausführungsform der Fig. 13 besteht jedoch darin, dass der Piezo-Aktuator 2 nicht auf dem Fußteil des Gestells 45 aufliegt, sondern innerhalb des kleineren Halbkreisbogens mit dem Radius R1 an einer Halterplatte 45' angeordnet und befestigt ist und über ein Verbindungselement 40 auf die den inneren Halbkreisbogen bildenden Hebel 33, 33' einwirkt. Dadurch werden die Lenkerhebel 32, 32' zu Antriebshebeln 33 und 33' umfunktioniert, während die den größeren Halbkreisbogen bildenden Hebel die Lenkerhebel 32 und 32' darstellen, die im Bereich der Symmetrieebene 31 auf dem Gestellteil 45 aufliegen. Das Gestellteil 45 ist starr mit der Tragplatte 45' verbunden und bildet somit das Gegenlager für die Lenkerhebel 32 und 32'.
Bei dieser Ausführungsform ist es zweckmäßig, die beiden Antriebshebel 33 und 33', also den von diesen beiden Hebeln gebildeten Halbkreisbogen, so auszubilden, dass seine Biegeelastizität möglichst gering ist und den von den beiden Antriebshebeln 32 und 32' gebildeten Kreisbogen mit dem größeren Radius R2 mit einer Biegeelastizität zu versehen, durch welche die den in diesem Falle nach unten gerichteten Antriebsimpulse des Piezo-Aktuators 2 die entgegengesetzte Rückstellkraft aufgebracht wird.

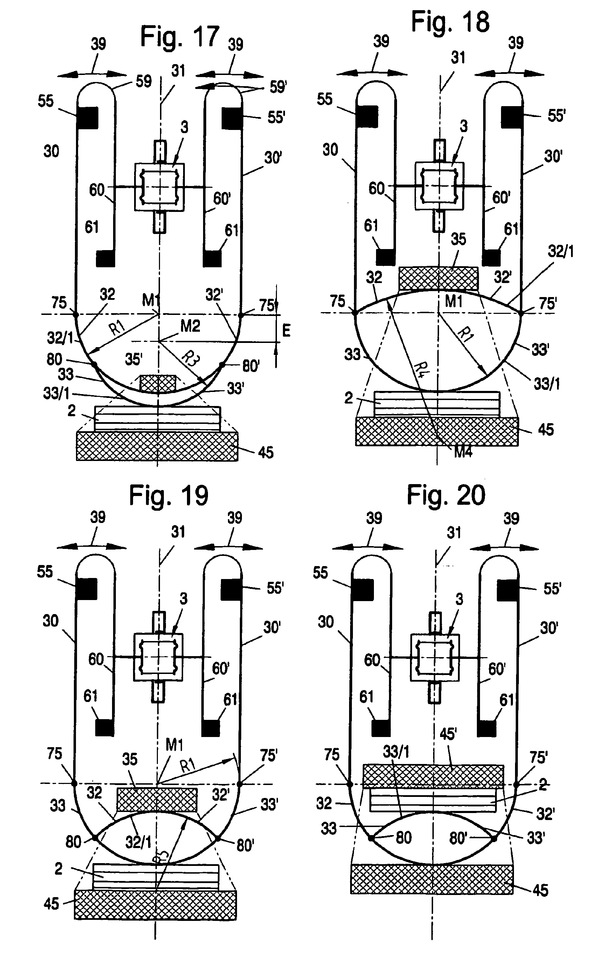

In den Fig. 17 bis 20 sind jeweils schematisch Ausführungsformen dargestellt, bei denen die beiderseits der Symmetrieebene 31 angeordneten und jeweils in der Symmetrieebene 31 miteinander verbundenen, bogenförmigen Lenkerhebel 32, 32' und Antriebshebel 33, 33' jeweils paarweise Kreisabschnitte sich schneidender Kreise bilden und an den Schnittstellen dieser Kreise miteinander verbunden sind. Die Schwingarme 30 und 30' sowie deren Balancearme 60 und 60' sind auch hierbei gleich ausgebildet und angeordnet wie bei den vorbeschriebenen Ausführungsformen. Bei der Ausführungsform der Fig. 17 bilden die beiden mit an den Verbindungspunkten 75, 75' mit den Schwingarmen 30, 30' verbundenen Lenkerhebel 32 und 32' jeweils gemeinsam einen Halbkreisbogen 32/1 mit dem Radius R1 und dem Krümmungsmittelpunkt M1. Die Enden der beiden Lenkerhebel 32, 32' sind an den Verbindungspunkten 80, 80' mit den Antriebshebeln 33, 33' verbunden. Die beiden Antriebshebel 33, 33', die in diesem Falle wesentlich kürzer ausgebildet sind als die beiden Lenkerhebel 32 und 32', bilden gemeinsam einen Kreisabschnitt 33/1 mit einem Radius R3, der kleiner ist als der Radius R1 und dessen Mittelpunkt M2 um das Maß E2 in der Symmetrieebene 31 nach unten, d. h. gegen den Piezo-Aktuator 2 versetzt ist. Dem von den beiden Lenkerhebeln 32 und 32' gebildeten Halbkreisbogen 32/1 ist wie bei den schon beschriebenen Ausführungsbeispielen ein Gegenlager 35' zugeordnet, das mit dem Fußteil des Gestells 45 verbunden ist und dafür sorgt, dass die in der Symmetrieebene 31 miteinander verbundenen Enden der Lenkerhebel 32, 32' vom Piezo-Aktuator 2 einen definierten Abstand haben und dass die beiden den Kreisbogen 33/1 bildenden Antriebshebel 33 und 33' an ihrer Verbindungsstelle, d. h. in der Symmetrieebene 31 auf dem Piezo-Aktuator 2 federnd aufliegen. Auch mit dieser Ausführungsform können die für den Betrieb der Fluidpumpe 3 erforderlichen Schwingungen der Schwingarme 30 und 30' durch die periodischen Kraftimpulse des Piezo-Aktuators 2 erzeugt werden.

Bei der Ausführungsform der Fig. 18 bilden die beiden Antriebshebel 33 und 33' gemeinsam einen Halbkreis 33/1 mit dem Radius R1 und dem Krümmungsmittelpunkt M1. Dabei sind die Enden der beiden Antriebshebel 33 und 33' jeweils an den Verbindungspunkten 75, 75' mit den unteren Enden der Schwingarme 30 bzw. 30' verbunden. Die im Bereich der Symmetrieebene 31 miteinander verbundenen Enden der Antriebshebel 33 und 33' liegen auch hier gemeinsam federnd auf dem Piezo-Aktuator 2 auf, der seinerseits auf dem Fußteil des Gestells 45 aufsitzt. Die beiden Lenkerhebel 32 und 32' bilden bei dieser Ausführungsform einen Kreisbogen 32/1, der zu dem Halbkreisbogen 33/1 der beiden Antriebshebel 33 und 33' entgegengesetzt gewölbt ist mit einem Radius R4, dessen Krümmungsmittelpunkt M4 im Bereich des Fußteils des Gestells 45 in der Symmetrieebene 31 liegt. Auch hierbei ist den beiden Lenkerhebeln 32, 32', die in diesem Falle ebenso wie die beiden Antriebshebel 33 und 33' biegeelastisch ausgebildet sein müssen, ein Gegenlager 35 zugeordnet, welches mit dem Fußteil des Gestells 45 starr bzw. einstellbar verbunden ist.

Die Ausführungsform der Fig. 19 unterscheidet sich von derjenigen der Fig. 18 nur dadurch, dass die beiden Lenkerhebel 32 und 32' einen Kreisbogen 32/1 bilden, der einen wesentlich kleineren Krümmungsradius R5 aufweist als der Kreisbogen 32/1 mit dem Krümmungsradius R4. Die beiden Lenkerhebel 32 und 32' sind jeweils an Verbindungspunkten 80 und 80' mit den einen Halbkreisbogen 33/1 bildenden Antriebshebeln 33, 33' verbunden. Auch hierbei müssen sowohl die Lenkerhebel 32 und 32' als auch die Antriebshebel 33 und 33', deren Enden an den Verbindungsstellen 75, 75' mit den Schwingarmen 30 und 30' in Verbindung stehen, biegeelastisch ausgeführt sein. Das auch hierbei vorgesehene Gegenlager 35' ist wie bei den anderen Ausführungsbeispielen auch fest mit dem Fußteil des Gestells 45 verbunden. Wie beim Ausführungsbeispiel der Fig. 18 werden die Kraftimpulse des Piezo-Aktuators 2 auf die den Halbkreisbogen 33/1 bildenden Antriebshebel 33 und 33' übertragen, wobei diese durch ihre Verbindung mit den jeweils kürzeren Lenkerhebeln 32 und 32' seitlich ausgelenkt werden und somit die pendelartigen Schwingungen der Schwingarme 30 und 30' bewirken.

Wie die Fig. 20 zeigt, ist es auch bei einer Ausführungsform gemäß der Fig. 19 möglich, den Piezo-Aktuator 2 innerhalb des Halbkreisbogens 32/1 bzw. zwischen den beiden Schwingarmen 30 und 30' anzuordnen und auch die beiden einen Kreisabschnitt 33/1 bildenden Hebel 33, 33', die bei den Verbindungspunkten 80 bzw. 80' mit den Antriebshebeln 32 bzw. 32' verbunden sind, einwirken zu lassen, so dass diese den Kreisabschnitt 32/1 bildenden Hebelarme in diesem Falle die Antriebshebel 33 bzw. 33' bilden, während die den Halbkreis 32/1 bildenden Hebelarme jeweils einen Lenkerhebel 32 bzw. 32' darstellen. Ähnlich wie bei der Ausführungsform der Fig. 14 ist der Piezo-Aktuator 2 in diesem Falle an einer Halteplatte 45' befestigt, so dass er mit seiner Unterseite unmittelbar auf den im Bereich der Symmetrieebene 31 miteinander verbundenen, den Kreisbogen 33/1 bildenden Antriebshebeln 33 und 33' aufliegt. Selbstverständlich ist auch hierbei die Halteplatte 45' fest mit dem Fußteil des Gestells 45 verbunden. Das Fußteil des Gestells 45 spielt hierbei die Rolle des Gegenlagers.

Die Fig. 21 zeigt schematisch eine Ausführungsform, die sich von derjenigen der Fig. 17 nur dadurch unterscheidet, dass die beiden Antriebshebel 33, 33' keinen Kreisbogen bilden, sondern aus angebogenen Endabschnitten eines flach auf dem Piezo-Aktuator 2 aufliegenden Biegeteils 81 bestehen. Die Enden dieser Endabschnitte sind jeweils an sich symmetrisch zur Symmetrieebene gegenüberliegenden Verbindungspunkten 80, 80' mit den gemeinsam einen Halbkreis 23/1 bildenden Lenkerhebeln 32, 32' bewegungsübertragend verbunden. Die Arbeitsweise ist im Wesentlichen die gleiche wie bei der Ausführungsform gemäß Fig. 17.

Die Variante der Fig. 22 bildet insofern ein Gegenstück zu der bereits beschriebenen Ausführungsform der Fig. 23, als der innerhalb des von den beiden Lenkerhebeln 32, 32' gebildeten Halbkreisbogens angeordnete Piezo-Aktuator 2 über gerade Antriebshebel 83, 83' mit den Lenkerhebeln 32, 32' in bewegungsübertragender Verbindung steht. Die beiden Antriebshebel 83, 83' sind an den symmetrisch angeordneten Verbindungspunkten 80, 80' jeweils mit einem Lenkerhebel 32, 32' verbunden. Ihre anderen Enden können an einer gemeinsamen Stelle oder getrennt über ein Kopplungsglied 85 mit dem Piezo-Aktuator 2 verbunden sein.

Bei allen gezeigten Ausführungsbeispielen besteht die Möglichkeit, die vorteilhaften Funktionsweisen und Herstellungsmöglichkeiten zu nutzen, insbesondere können alle Schwingsysteme 1, l'jeweils bestehend aus zwei Schwingarmen 30, 30', zwei Balancearmen 60, 60', zwei Lenkerhebeln 32, 32' bzw. 64, 64' und zwei Antriebshebeln 33, 33' bzw. 63, 63' einstückig aus Kunststoff als Spritzgussteil gefertigt und auf einfache Weise, z. B. ohne Schraubverbindungen, funktionsfähig in ein Gestell 45 eingesetzt werden.

## Patentansprüche

1. Elektrischer Schwingantrieb mit wenigstens einem von einem periodische Kraftimpulse mit kleiner Bewegungsamplitude erzeugenden Aktuator, insbesondere einem Piezo-Aktuator (2) oder einem Schwingankermagneten, mit angepasster Eigenfrequenz in einer vorgegebenen Ebene (38) schwingend angetriebenen Schwingsystem (1), das wenigstens einen Schwingbewegungen ausführenden Schwingarm (30') mit einer Resonanzmasse (55') und mit einem Balancearm (60') aufweist, der über ein Kopplungsglied des Balancearms (60') mit einem oszillierend anzutreibenden Arbeitsorgan (7) eines Arbeitsgerätes, insbesondere einer Pumpe (3), in mechanischer Antriebsverbindung steht,
**dadurch gekennzeichnet,**
**dass** der Schwingarm (30, 30') an zwei ungleich langen Hebeln, nämlich einem Lenkerhebel (32') und einem Antriebshebel (33'), befestigt ist, wobei wenigstens einer dieser beiden Hebel, insbesondere der Lenkerhebel (32'), wenigstens abschnittweise biegeelastisch ausgebildet ist und sein nicht mit dem Schwingarm (30') verbundenes Ende an einer vom Schwingarm (30') entfernten Stelle unbeweglich mit einem Gestellteil (45, 62) verbunden ist, in dem der Aktuator (2) gelagert ist, und wobei der Antriebshebel (33') mit dem Aktuator (2) derart in bewegungsübertragender Verbindung steht, dass die Kraftimpulse des Aktuators (2) dem Schwingarm (30') zur Erzeugung pendelartiger Schwingbewegungen in einer Richtung zugeführt werden, die zumindest annähernd parallel zu dessen Erstreckungsrichtung in der Ruhelage verläuft.

2. Elektrischer Schwingantrieb mit wenigstens einem von einem periodische Kraftimpulse mit kleiner Bewegungsamplitude erzeugenden Aktuator, insbesondere einem Piezo-Aktuator (2) oder einem Schwingankermagneten, mit angepasster Eigenfrequenz in einer vorgegebenen Ebene (38) schwingend angetriebenen Schwingsystem (1), das wenigstens einen Schwingarm (30, 30') mit einer Resonanzmasse (55, 55') und mit einem Balancearm (60, 60') aufweist, der Schwingbewegungen ausführt und über ein Kopplungsglied (16, 17) des Balancearms (60, 60') mit einem oszillierend anzutreibenden Arbeitsorgan (6, 7) eines Arbeitsgerätes, insbesondere einer Pumpe (3), in mechanischer Antriebsverbindung steht,
**dadurch gekennzeichnet,**
**dass** in symmetrischer Anordnung zu einer Symmetrieebene (31) zwei Schwingarme (30, 30') vorgesehen sind, die jeweils an einem Paar von zwei ungleich langen Hebeln, nämlich einem Lenkerhebel (32, 32') und einem Antriebshebel (33, 33'), befestigt sind, wobei jeweils wenigstens einer dieser beiden Hebel, insbesondere der Lenkerhebel (32, 32'), wenigstens abschnittweise biegeelastisch ausgebildet ist und sein nicht mit einem Schwingarm (30, 30') verbundenes Ende an einer vom Schwingarm (30, 30') entfernten Stelle unbeweglich mit einem Gestellteil (45, 62) verbunden ist, in dem der Aktuator (2) gelagert ist, und wobei die Antriebshebel (33, 33', 64, 64') mit dem Aktuator (2) derart in bewegungsübertragender Verbindung stehen, dass die Kraftimpulse des Aktuators (2) den Schwingarmen (30, 30') zur Erzeugung pendelartiger Schwingbewegungen in einer Richtung zugeführt werden, die zumindest annähernd parallel zu deren Erstreckungsrichtung in der Ruhelage verläuft.

3. Elektrischer Schwingantrieb nach Anspruch 2, **dadurch gekennzeichnet, dass** die Symmetrieebene vertikal verläuft.

4. Elektrischer Schwingantrieb nach Anspruch 1 oder 2, **dadurch gekennzeichnet, dass** der Schwingarm (30') bzw. die Schwingarme (30, 30'), deren Balancearme (60, 60') sowie die Lenkerhebel (32,32') und Antriebshebel 33, 33') jeweils aus formstabilem Kunststoff besteht bzw. bestehen und dass die jeweils einem Schwingarm (30, 30') zugeordneten Balancearme (60, 60'), Lenkerhebel (32, 32') und Antriebshebel (33, 33') jeweils über biegeelastische Verbindungsglieder einstückig mit diesem verbunden sind.

5. Elektrischer Schwingantrieb nach Anspruch 2 oder 4, **dadurch gekennzeichnet, dass** die Balancearme (60, 60') aus formstabilem, allenfalls schwach biegeelastischem Kunststoff bestehen und dass die Schwingbewegungen der beiden sich beiderseits der Symmetrieebene (31) symmetrisch gegenüber stehenden Schwingarme (30, 30') und deren Balancearme (60, 60') gegenläufig synchron verlaufen.

6. Elektrischer Schwingantrieb nach Anspruch 5, **dadurch gekennzeichnet, dass** die Verbindungen zwischen den Schwingarmen (30, 30') und Lenkerhebeln (32, 32') sowie den Antriebshebeln (33, 33') auf beiden Seiten der Symmetrieebene (31) jeweils spiegelbildlich zueinander angeordnet sind.

7. Elektrischer Schwingantrieb nach Anspruch 2 oder 3, **dadurch gekennzeichnet, dass** die Schwingarme (30, 30') und/oder die Balancearme (60, 60') in ihrer Ruhelage zur gemeinsamen Symmetrieebene (31) eine zumindest annähernd parallele Lage einnehmen.

8. Elektrischer Schwingantrieb nach einem der Ansprüche 1, 2 oder 3 bis 7, **dadurch gekennzeichnet, dass** der Balancearm (60, 60') zumindest annähernd gleich lang ist wie der Schwingarm (30, 30') und mit diesem synchron schwingt.

9. Elektrischer Schwingantrieb nach Anspruch 1 oder 2, **dadurch gekennzeichnet, dass** die Lenkerhebel (32, 32') jeweils außerhalb der Erstreckungsebene des jeweils mit ihnen verbundenen Schwingarms (30, 30') in einem definierten Abstand vom Aktuator (2) gelagert sind.

10. Elektrischer Schwingantrieb nach einem der Ansprüche 2 bis 9, **dadurch gekennzeichnet, dass** die Lenkerhebel (32, 32') und/oder die Antriebshebel (33, 33') in symmetrischer Anordnung zur Symmetrieebene (31) jeweils bogenförmig ausgebildet und paarweise im Bereich der Symmetrieebene (31) miteinander verbunden sind.

11. Elektrischer Schwingantrieb nach Anspruch 9, **dadurch gekennzeichnet, dass** die jeweils beiderseits der Symmetrieebene (31) angeordneten Lenkerhebel (32, 32') und Antriebshebel (33, 33') sich jeweils paarweise zu einem Halbkreis ergänzen.

12. Elektrischer Schwingantrieb nach Anspruch 11, **dadurch gekennzeichnet, dass** die von den Lenkerhebeln (32, 32') und den Antriebshebeln (33, 33') gebildeten Halbkreise jeweils unterschiedliche Radien (R1, R2) mit gleichen Mittelpunkten (M) aufweisen.

13. Elektrischer Schwingantrieb nach Anspruch 11, **dadurch gekennzeichnet, dass** die von den Lenkerhebeln (32, 32') und den Antriebshebeln (33, 33') gebildeten Halbkreise jeweils gleiche Radien (R1) mit in der Symmetrieebene (31) zueinander versetzten Mittelpunkten (Ml, M2) aufweisen.

14. Elektrischer Schwingantrieb nach Anspruch 10, **dadurch gekennzeichnet, dass** die beiderseits der Symmetrieebene (31) angeordneten und jeweils in der Symmetrieebene (31) miteinander verbundenen, bogenförmigen Lenkerhebel (32, 32') und Antriebshebel (33, 33') jeweils paarweise Kreisabschnitte sich schneidender Kreise bilden, und an den Schnittstellen dieser Kreise miteinander verbunden sind.

15. Elektrischer Schwingantrieb nach einem der Ansprüche 2 bis 6, **dadurch gekennzeichnet, dass** die Antriebshebel (63, 63') im Bereich der Symmetrieebene (31) biegeelastisch oder gelenkartig miteinander verbunden sind.

16. Elektrischer Schwingantrieb nach einem der Ansprüche 2 bis 6, **dadurch gekennzeichnet, dass** die beiden Antriebshebel (83, 83') jeweils separat über ein Kopplungselement mit dem Aktuator (2) verbunden sind.

17. Elektrischer Schwingantrieb nach einem der Ansprüche 2 bis 6, **dadurch gekennzeichnet, dass** die beiden Balancearme (60, 60') sich beiderseits der Symmetrieebene (31) unmittelbar gegenüberstehen und jeweils mit einer Pumpmembrane (6, 7) einer gemeinsamen Pumpkammer (5) einer Fluidpumpe (3) in Wirkverbindung stehen, die zwischen den beiden Balancearmen (60, 60') angeordnet ist.

18. Elektrischer Schwingantrieb nach einem der Ansprüche 1, 2 bis 6 oder 17, **dadurch gekennzeichnet, dass** zwischen dem (den) Balancearm(en) (60, 60') und dem (den) Arbeitsorgan(en) (6, 7) des Arbeitsgerätes (3) eine federelastische Antriebsverbindung besteht.

19. Elektrischer Schwingantrieb nach einem der Ansprüche 2 bis 18, **dadurch gekennzeichnet, dass** der Aktuator (2) außerhalb der bogenförmigen Lenker- (32, 32') und Antriebshebel (33, 33') angeordnet ist.

20. Elektrischer Schwingantrieb nach einem der Ansprüche 2 bis 18, **dadurch gekennzeichnet, dass** der Aktuator (2) innerhalb der bogenförmigen Lenker- (32, 32') und Antriebshebel (33, 33') angeordnet ist.

21. Elektrischer Schwingantrieb nach einem der Ansprüche 1, 2 oder 10 bis 15, **dadurch gekennzeichnet, dass** der bzw. die Lenkerhebel (32, 32') unter der Wirkung einer Federkraft an einem Gegenlager (35) anliegen, das vom Aktuator (2) einen definierten Abstand hat und auf der dem Aktuator (2) gegenüberliegenden Seite der Lenkerhebel (32, 32') angeordnet ist.

22. Elektrischer Schwingantrieb nach einem der Ansprüche 2 bis 21, **dadurch gekennzeichnet, dass** die beiden Antriebshebel (33, 33') gemeinsam außerhalb der Lenkerhebel (32, 32') angeordnet und mit einem zur Symmetrieebene (31) symmetrisch ausgebildeten Fußteil (36) versehen sind, das als Kopplungsglied federnd mit der Arbeitfläche eines Aktuators (2) in Verbindung steht.

23. Elektrischer Schwingantrieb nach Anspruch 22, **dadurch gekennzeichnet, dass** die beiden Antriebshebel (33, 33') jeweils separat mit einem von zwei getrennt voneinander angeordneten, jedoch von einer gemeinsam Spannungsquelle gespeisten Aktuatoren (2/1, 2/2) über separate Fußteile (36/1, 36/2) in Wirkverbindung stehen.

24. Elektrischer Schwingantrieb nach einem der Ansprüche 2 bis 23, **dadurch gekennzeichnet, dass** die beiden Lenkerhebel (32, 32') auf ihrer den Antriebshebeln (33, 33') gegenüberliegenden Seite mit einem zur Symmetrieebene (33) symmetrisch ausgebildeten als Gegenlager zu den Antriebshebeln (33, 33') wirkenden Stützteil (35) versehen sind, das mit einem dem Aktuator (2) als festes Lager dienenden Gestellteil (45) unbeweglich verbunden ist.

25. Elektrischer Schwingantrieb nach einem der Ansprüche 23 oder 24, **dadurch gekennzeichnet, dass** das Gestellteil (45) mit zwei den Fußteil (36) der beiden Antriebshebel (33, 33') und den Aktuator (2) zwischen sich aufnehmenden Wandelementen (47, 47') versehen ist, an denen das Stützteil (35) befestigt ist.

26. Elektrischer Schwingantrieb nach einem der Ansprüche 23 bis 25, **dadurch gekennzeichnet, dass** an oder auf dem Stützteil (35) die zwischen den beiden Balancearmen (60, 60') angeordnete Fluidpumpe (3) befestigt ist.

27. Elektrischer Schwingantrieb nach einem der Ansprüche 2 bis 22, **dadurch gekennzeichnet, dass** die beiden Antriebshebel (33, 33') zwischen den beiden Lenkerhebeln (32, 32') gemeinsam einen zusammenhängenden, gegen ein Fußteil (36) gekrümmten Bogen, insbesondere Kreisbogen, bilden, dessen Enden jeweils einstückig mit einem der Schwingarme (30, 30') verbunden sind und dessen Mittelabschnitt bewegungsübertragend auf dem Aktuator (2) aufliegt.

28. Elektrischer Schwingantrieb nach Anspruch 27, **dadurch gekennzeichnet, dass** die beiden einstückig mit jeweils einem Schwingarm (30, 30') verbundenen Lenkerhebel (32, 32') an den einander entgegengesetzten Seiten des Fußteils (36) einstückig angeformt und jeweils außerhalb der Antriebshebel (33, 33') mit den Schwingarmen (30, 30') verbunden sind.

29. Elektrischer Schwingantrieb nach einem der Ansprüche 27 oder 28, **dadurch gekennzeichnet, dass** der Aktuator (2) zwischen dem von den beiden Antriebsarmen (63, 63') gebildeten zusammenhängenden Bogen und dem Fußteil (62) angeordnet ist.

30. Elektrischer Schwingantrieb nach einem der Ansprüche 27 oder 28, **dadurch gekennzeichnet, dass** am Fußteil (62) ein Sockelteil (65) befestigt ist, das an einem seitlichen Wandelement einen auf der konkaven Seite des von den beiden Antriebshebeln (63, 63') gebildeten Bogens einen Trägerarm (67)für die Fluidpumpe (3) aufweist.

## Claims

1. Electrical vibration drive with at least one vibration system (1) which is driven vibrationally with a matched characteristic frequency in a stipulated plane (38) by an actuator, in particular piezo-actuator (2) or vibratingarmature magnet, generating periodic force pulses with low amplitude of movement and which has at least one vibrating arm (30') executing vibrating movements, with a resonant mass (55') and with a balance arm (60') which is drive-connected mechanically, via a coupling member of the balance arm (60'), to a working member (7), to be driven in oscillation, of a working appliance, in particular a pump (3), **characterized in that** the vibrating arm (30, 30') is fastened to two levers of unequal length, to be precise to a link lever (32') and to a drive lever (33'), at least one of these two levers, in particular the link lever (32'), being designed to be at least partially flexurally elastic, and its end not connected to the vibrating arm (30') being connected immovably, at a point remote from the vibrating arm (30'), to a stand part (45, 62) in which the actuator (2) is mounted, and the drive lever (33') being in movement-transmitting connection to the actuator (2) in such a way that the force pulses of the actuator (2) are delivered to the vibrating arm (30') for generating pendulum-like vibrating movements in a direction which runs at least approximately parallel to its direction of extent in the position of rest.

2. Electrical vibration drive with at least one vibration system (1) which is driven vibrationally with a matched characteristic frequency in a stipulated plane (38) by an actuator, in particular piezo-actuator (2) or vibratingarmature magnet, generating periodic force pulses with low amplitude of movement and which has at least one vibrating arm (30, 30') with a resonant mass (55, 55') and with a balance arm (60, 60') which executes vibrating movements and which is drive-connected mechanically, via a coupling member (16, 17) of the balance arm (60, 60'), to a working member (6, 7), to be driven in oscillation, of a working appliance, in particular a pump (3), **characterized in that** there are provided in symmetrical arrangement with respect to a plane of symmetry (31) two vibrating arms (30, 30') which are fastened in each case to a pair of two levers of unequal length, to be precise a link lever (32, 32') and a drive lever (33, 33'), in each case at least one of these two levers, in particular the link lever (32, 32'), being designed to be at least partially flexurally elastic, and its end not connected to a vibrating arm (30, 30') being connected immovably, at a point remote from the vibrating arm (30, 30'), to a stand part (45, 62) in which the actuator (2) is mounted, and the drive levers (33, 33', 64, 64') being in movement-transmitting connection to the actuator (2) in such a way that the force pulses of the actuator (2) are delivered to the vibrating arms (30, 30') for generating pendulum-like vibrating movements in a direction which runs at least approximately parallel to their direction of extent in the position of rest.

3. Electrical vibration drive according to Claim 2, **characterized in that** the plane of symmetry runs vertically.

4. Electrical vibration drive according to Claim 1 or 2, **characterized in that** the vibrating arm (30') or vibrating arms (30, 30'), their balance arms (60, 60') and also the link levers (32, 32') and drive levers (33, 33') consists or consist in each case of dimensionally stable plastic, and **in that** the balance arms (60, 60'), link levers (32, 32') and drive levers (33, 33') assigned in each case to a vibrating arm (30, 30') are connected in one piece to the latter in each case via flexurally elastic connecting members.

5. Electrical vibration drive according to Claim 2 or 4, **characterized in that** the balance arms (60, 60') consist of dimensionally stable, at most slightly flexurally elastic plastic, and **in that** the vibrating movements of the two vibrating arms (30, 30') and of their balance arms (60, 60'), in each case standing symmetrically opposite one another on both sides of the plane of symmetry (31), run contra directionally in synchronism.

6. Electrical vibration drive according to Claim 5, **characterized in that** the connections between the vibrating arms (30, 30') and the link levers (32, 32') and drive levers (33, 33') are arranged on both sides of the plane of symmetry (31) in each case mirror-symmetrically to one another.

7. Electrical vibration drive according to Claim 2 or 3, **characterized in that** the vibrating arms (30, 30') and/or the balance arms (60, 60') assume an at least approximately parallel position with respect to the common plane of symmetry (31) in their position of rest.

8. Electrical vibration drive according to one of Claims 1, 2 or 3 to 7, **characterized in that** the balance arm (60, 60') is of at least approximately equal length to the vibrating arm (30, 30') and vibrates synchronously with the latter.

9. Electrical vibration drive according to Claim 1 or 2, **characterized in that** the link levers (32, 32') are mounted in each case at a defined distance from the actuator (2) outside the plane of extent of the vibrating arm (30, 30') connected in each case to them.

10. Electrical vibration drive according to one of Claims 2 to 9, **characterized in that** the link levers (32, 32') and/or the drive levers (33, 33') are in each case formed arcuately in a symmetrical arrangement with respect to the plane of symmetry (31) and are connected to one another in pairs in the region of the plane of symmetry (31).

11. Electrical vibration drive according to Claim 9, **characterized in that** the link levers (32, 32') and drive levers (33, 33') arranged in each case on both sides of the plane of symmetry (31) complement one another in each case in pairs to form a semicircle.

12. Electrical vibration drive according to Claim 11, **characterized in that** the semicircles formed by the link levers (32, 32') and the drive levers (33, 33') have in each case different radii (R1, R2) with identical centre points (M).

13. Electrical vibration drive according to Claim 11, **characterized in that** the semicircles formed by the link levers (32, 32') and the drive levers (33, 33') have in each case identical radii (R1) with centre points (M1, M2) which are offset to one another in the plane of symmetry (31).

14. Electrical vibration drive according to Claim 10, **characterized in that** the arcuate link levers (32, 32') and drive levers (33, 33') arranged on both sides of the plane of symmetry (31) and connected in each case to one another in the plane of symmetry (31) form in each case in pairs circle segments of intersecting circles and are connected to one another at the intersection points of these circles.

15. Electrical vibration drive according to one of Claims 2 to 6, **characterized in that** the drive levers (63, 63') are connected to one another in a flexurally elastic or joint-like manner in the region of the plane of symmetry (31).

16. Electrical vibration drive according to one of Claims 2 to 6, **characterized in that** the two drive levers (83, 83') are in each case connected separately to the actuator (2) via a coupling element.

17. Electrical vibration drive according to one of Claims 2 to 6, **characterized in that** the two balance arms (60, 60') stand directly opposite one another on both sides of the plane of symmetry (31) and are operatively connected in each case to a pumping diaphragm (6, 7) of a common pumping chamber (5) of a fluid pump (3) which is arranged between the two balance arms (60, 60').

18. Electrical vibration drive according to one of Claims 1, 2 to 6 or 17, **characterized in that** a spring-elastic drive connection is present between the balance arm or balance arms (60, 60') and the working member or working members (6, 7) of the working appliance (3).

19. Electrical vibration drive according to one of Claims 2 to 18, **characterized in that** the actuator (2) is arranged outside the arcuate link levers (32, 32') and drive levers (33, 33').

20. Electrical vibration drive according to one of Claims 2 to 18, **characterized in that** the actuator (2) is arranged inside the arcuate link levers (32, 32') and drive levers (33, 33').

21. Electrical vibration drive according to one of Claims 1, 2 or 10 to 15, **characterized in that** the link lever or link levers (32, 32') bears or bear under the action of a spring force against a counterbearing (35) which is at a defined distance from the actuator (2) and which is arranged on that side of the link levers (32, 32') which lies opposite the actuator (2).

22. Electrical vibration drive according to one of Claims 2 to 21, **characterized in that** the two drive levers (33, 33') are arranged together outside the link levers (32, 32') and are provided with a foot part (36) which is formed symmetrically with respect to the plane of symmetry (31) and which is resiliently connected as a coupling member to the working surface of an actuator (2).

23. Electrical vibration drive according to Claim 22, **characterized in that** the two drive levers (33, 33') are in each case operatively connected separately via separate foot parts (36/1, 36/2) to one of two actuators (2/1, 2/2) arranged separately from one another, but fed by a common voltage source.

24. Electrical vibration drive according to one of Claims 2 to 23, **characterized in that** the two link levers (32, 32') are provided, on their side laying opposite the drive levers (33, 33'), with a supporting part (35) which is formed symmetrically with respect to the plane of symmetry (33) and acts as a counterbearing to the drive levers (33, 33') and which is connected immovably to a stand part (45) serving as a fixed bearing for the actuator (2).

25. Electrical vibration drive according to either of Claims 23 and 24, **characterized in that** the stand part (45) is provided with two wall elements (47, 47') which between them receive the foot part (36) of the two drive levers (33, 33') and the actuator (2) and to which the supporting part (35) is fastened.

26. Electrical vibration drive according to one of Claims 23 to 25, **characterized in that** the fluid pump (3) arranged between the two balance arms (60, 60') is fastened to or on the supporting part (35).

27. Electrical vibration drive according to one of Claims 2 to 22, **characterized in that** the two drive levers (33, 33') together form between the two link levers (32, 32') a coherent arc, in particular circle arc, which is curved towards the foot part (36) and the ends of which are in each case connected in one piece to one of the vibrating arms (30, 30') and the middle portion of which lies on the actuator (2) in a movement-transmitting manner.

28. Electrical vibration drive according to Claim 27, **characterized in that** the two link levers (32, 32') connected in each case in one piece to a vibrating arm (30, 30') are formed in one piece on the mutually opposite side of the foot part (36) and are in each case connected to the vibrating arms (30, 30') outside the drive levers (33, 33').

29. Electrical vibration drive according to either one of Claims 27 and 28, **characterized in that** the actuator (2) is arranged between the coherent arc formed by the two drive arms (63, 63') and the foot part (62).

30. Electrical vibration drive according to either one of Claims 27 and 28, **characterized in that** the foot part (62) has fastened to it a plinth part (65) which has on a lateral wall element a carrier arm (67) for the fluid pump (3) on the concave side of the arc formed by the two drive levers (63, 63').

## Revendications

1. Commande oscillante électrique comprenant au moins un système oscillant (1) entraîné de manière oscillante dans un plan prédéfini (38) par un actionneur produisant des impulsions de force périodiques de petite amplitude de mouvement, en particulier un actionneur piézoélectrique (2) ou un aimant d'induit oscillant, avec une fréquence propre adaptée, lequel système oscillant présente au moins un bras oscillant (30') effectuant des mouvements d'oscillation, avec une masse de résonance (55') et avec un bras d'équilibrage (60'), qui est en liaison d'entraînement mécanique par le biais d'un organe d'accouplement du bras d'équilibrage (60') avec un organe de travail (7) d'un engin de travail à entraîner de manière oscillante, en particulier une pompe (3),
**caractérisée en ce que**
le bras oscillant (30, 30') est fixé à deux leviers de longueurs différentes, à savoir un levier de direction (32') et un levier d'entraînement (33'), au moins l'un de ces deux leviers, en particulier le levier de direction (32'), étant réalisé au moins en partie de manière élastique en flexion, et son extrémité non connectée au bras oscillant (30') étant connectée au niveau d'un point éloigné du bras oscillant (30') de manière immobile à une partie du bâti (45, 62) dans laquelle est monté l'actionneur (2), et le levier d'entraînement (33') étant en liaison par transmission de mouvement avec l'actionneur (2) de telle sorte que les impulsions de force de l'actionneur (2) soient transmises au bras oscillant (30') pour générer des mouvements d'oscillation de type pendulaire dans une direction qui s'étend au moins approximativement parallèlement à sa direction d'étendue dans la position de repos.

2. Commande oscillante électrique comprenant au moins un système oscillant (1) entraîné de manière oscillante dans un plan prédéfini (38) par un actionneur produisant des impulsions de force périodiques de petite amplitude de mouvement, en particulier un actionneur piézoélectrique (2) ou un aimant d'induit oscillant, avec une fréquence propre adaptée, lequel système oscillant présente au moins un bras oscillant (30, 30') avec une masse de résonance (55, 55') et avec un bras d'équilibrage (60, 60'), qui effectue des mouvements d'oscillation et qui est en liaison d'entraînement mécanique par le biais d'un organe d'accouplement (16, 17) du bras d'équilibrage (60, 60') avec un organe de travail (6, 7) d'un engin de travail à entraîner de manière oscillante, en particulier une pompe (3),
**caractérisée en ce que**
deux bras oscillants (30, 30') agencés symétriquement par rapport à un plan de symétrie (31) sont prévus, lesquels sont fixés à chaque fois à une paire de deux leviers de longueurs différentes, à savoir un levier de direction (32, 32') et un levier d'entraînement (33, 33'), à chaque fois au moins l'un de ces deux leviers, en particulier le levier de direction (32, 32'), étant réalisé au moins en partie de manière élastique en flexion, et son extrémité non connectée à un bras oscillant (30, 30') étant connectée au niveau d'un point éloigné du bras oscillant (30, 30') de manière immobile à une partie du bâti (45, 62) dans laquelle est monté l'actionneur (2), et les leviers d'entraînement (33, 33', 64, 64') étant en liaison par transmission de mouvement avec l'actionneur (2) de telle sorte que les impulsions de force de l'actionneur (2) soient transmises aux bras oscillants (30, 30') pour générer des mouvements d'oscillation de type pendulaire dans une direction qui s'étend au moins approximativement parallèlement à leur direction d'étendue dans la position de repos.

3. Commande oscillante électrique selon la revendication 2, **caractérisée en ce que** le plan de symétrie s'étend verticalement.

4. Commande oscillante électrique selon la revendication 1 ou 2, **caractérisée en ce que** le bras oscillant (30') ou les bras oscillants (30, 30'), leurs bras d'équilibrage (60, 60') ainsi que les leviers de direction (32, 32') et les leviers d'entraînement (33, 33') se composent chacun de plastique de forme stable et **en ce que** les bras d'équilibrage (60, 60'), les leviers de direction (32, 32') et les leviers d'entraînement (33, 33') associés à chaque fois à un bras oscillant (30, 30') sont connectés d'une seule pièce à celui-ci à chaque fois par le biais d'organes de liaison élastiques en flexion.

5. Commande oscillante électrique selon la revendication 2 ou 4, **caractérisée en ce que** les bras d'équilibrage (60, 60') se composent de plastique de forme stable, mais de faible élasticité en flexion, et **en ce que** les mouvements d'oscillation des deux bras oscillants (30, 30') symétriquement opposés de chaque côté du plan de symétrie (31) et de leurs bras d'équilibrage (60, 60') se produisent de manière synchrone et en sens inverse.

6. Commande oscillante électrique selon la revendication 5, **caractérisée en ce que** les connexions entre les bras oscillants (30, 30') et les leviers de direction (32, 32') ainsi que les leviers d'entraînement (33, 33') sont disposées les unes par rapport aux autres des deux côtés du plan de symétrie (31) à chaque fois avec une symétrie miroir.

7. Commande oscillante électrique selon la revendication 2 ou 3, **caractérisée en ce que** les bras oscillants (30, 30') et/ou les bras d'équilibrage (60, 60') adoptent dans leur position de repos une position au moins approximativement parallèle par rapport au plan de symétrie commun (31).

8. Commande oscillante électrique selon l'une quelconque des revendications 1, 2 ou 3 à 7, **caractérisée en ce que** le bras d'équilibrage (60, 60') a au moins approximativement la même longueur que le bras oscillant (30, 30') et oscille de manière synchrone avec celui-ci.

9. Commande oscillante électrique selon la revendication 1 ou 2, **caractérisée en ce que** les leviers de direction (32, 32') sont montés à chaque fois à l'extérieur du plan d'étendue du bras oscillant (30, 30') connecté respectivement à ceux-ci à une distance définie de l'actionneur (2).

10. Commande oscillante électrique selon l'une quelconque des revendications 2 à 9, **caractérisée en ce que** les leviers de direction (32, 32') et/ou les leviers d'entraînement (33, 33') sont réalisés suivant un agencement symétrique par rapport au plan de symétrie (31) à chaque fois sous forme courbe, et sont connectés les uns aux autres par paires dans la région du plan de symétrie (31).

11. Commande oscillante électrique selon la revendication 9, **caractérisée en ce que** les leviers de direction (32, 32') et les leviers d'entraînement (33, 33') disposés à chaque fois des deux côtés du plan de symétrie (31) se complètent à chaque fois par paires pour former un demi-cercle.

12. Commande oscillante électrique selon la revendication 11, **caractérisée en ce que** les demi-cercles formés par les leviers de direction (32, 32') et les leviers d'entraînement (33, 33') présentent à chaque fois différents rayons (R1, R2) de même centre (M).

13. Commande oscillante électrique selon la revendication 11, **caractérisée en ce que** les demi-cercles formés par les leviers de direction (32, 32') et les leviers d'entraînement (33, 33') présentent à chaque fois les mêmes rayons (R1) avec des centres (M1, M2) décalés l'un par rapport à l'autre dans le plan de symétrie (31).

14. Commande oscillante électrique selon la revendication 10, **caractérisée en ce que** les leviers de direction (32, 32') et les leviers d'entraînement (33, 33') de forme courbe, disposés des deux côtés du plan de symétrie (31) et à chaque fois connectés l'un à l'autre dans le plan de symétrie (31) forment à chaque fois des sections de cercle par paires de cercles s'intersectant, et sont connectés l'un à l'autre aux points d'intersection de ces cercles.

15. Commande oscillante électrique selon l'une quelconque des revendications 2 à 6, **caractérisée en ce que** les leviers d'entraînement (63, 63') sont connectés l'un à l'autre de manière élastique en flexion ou à la manière d'une articulation dans la région du plan de symétrie (31).

16. Commande oscillante électrique selon l'une quelconque des revendications 2 à 6, **caractérisée en ce que** les deux leviers d'entraînement (83, 83') sont connectés à chaque fois séparément à l'actionneur (2) par le biais d'un élément d'accouplement.

17. Commande oscillante électrique selon l'une quelconque des revendications 2 à 6, **caractérisée en ce que** les deux bras d'équilibrage (60, 60') sont directement en regard l'un de l'autre des deux côtés du plan de symétrie (31) et sont en liaison fonctionnelle à chaque fois avec une membrane de pompe (6, 7) d'une chambre de pompe commune (5) d'une pompe fluidique (3), qui est disposée entre les deux bras d'équilibrage (60, 60').

18. Commande oscillante électrique selon l'une quelconque des revendications 1, 2 à 6 ou 17, **caractérisée en ce qu'**entre le ou les bras d'équilibrage (60, 60') et le ou les organes de travail (6, 7) de l'engin de travail (3) existe une connexion d'entraînement élastique à ressort.

19. Commande oscillante électrique selon l'une quelconque des revendications 2 à 18, **caractérisée en ce que** l'actionneur (2) est disposé à l'extérieur des leviers de direction (32, 32') et des leviers d'entraînement (33, 33') de forme courbe.

20. Commande oscillante électrique selon l'une quelconque des revendications 2 à 18, **caractérisée en ce que** l'actionneur (2) est disposé à l'intérieur des leviers de direction (32, 32') et des leviers d'entraînement (33, 33') de forme courbe.

21. Commande oscillante électrique selon l'une quelconque des revendications 1, 2 ou 10 à 15, **caractérisée en ce que** le ou les leviers de direction (32, 32') s'appliquent sous l'effet d'une force de ressort contre un contre-palier (35) qui est espacé de l'actionneur (2) d'une distance définie, et qui est disposé du côté des leviers de direction (32, 32') opposé à l'actionneur (2).

22. Commande oscillante électrique selon l'une quelconque des revendications 2 à 21, **caractérisée en ce que** les deux leviers d'entraînement (33, 33') sont disposés ensemble à l'extérieur des leviers de direction (32, 32') et sont pourvus d'une partie de base (36) réalisée de manière symétrique par rapport au plan de symétrie (31), qui est en liaison élastique en tant qu'organe d'accouplement avec la surface de travail d'un actionneur (2).

23. Commande oscillante électrique selon la revendication 22, **caractérisée en ce que** les deux leviers d'entraînement (33, 33') sont en liaison fonctionnelle à chaque fois séparément par le biais de parties de base séparées (36/1, 36/2) avec l'un de deux actionneurs (2/1, 2/2) disposés séparément l'un de l'autre, mais alimentés par une source de tension commune.

24. Commande oscillante électrique selon l'une quelconque des revendications 2 à 23, **caractérisée en ce que** les deux leviers de direction (32, 32') sont pourvus, sur leur côté opposé aux leviers d'entraînement (33, 33'), d'une partie de support (35) réalisée de manière symétrique par rapport au plan de symétrie (33) et agissant en tant que contre-palier pour les leviers d'entraînement (33, 33'), laquelle est connectée de manière immobile à une partie de bâti (45) servant de palier fixe pour l'actionneur (2).

25. Commande oscillante électrique selon l'une quelconque des revendications 23 ou 24, **caractérisée en ce que** la partie de bâti (45) est munie de deux éléments de paroi (47, 47') recevant entre eux la partie de base (36) des deux leviers d'entraînement (33, 33') et l'actionneur (2), au niveau desquels éléments de paroi est fixée la partie de support (35).

26. Commande oscillante électrique selon l'une quelconque des revendications 23 à 25, **caractérisée en ce qu'**au niveau de ou sur la partie de support (35) est fixée la pompe fluidique (3) disposée entre les deux bras d'équilibrage (60, 60').

27. Commande oscillante électrique selon l'une quelconque des revendications 2 à 22, **caractérisée en ce que** les deux leviers d'entraînement (33, 33') forment ensemble entre les deux leviers de direction (32, 32') un arc continu cintré vers une partie de base (36), en particulier un arc de cercle, dont les extrémités sont connectées à chaque fois d'une seule pièce à l'un des bras oscillants (30, 30') et dont la section centrale repose avec transmission du mouvement sur l'actionneur (2).

28. Commande oscillante électrique selon la revendication 27, **caractérisée en ce que** les deux leviers de direction (32, 32') connectés d'une seule pièce à un bras oscillant respectif (30, 30') sont façonnés d'une seule pièce au niveau des côtés opposés l'un à l'autre de la partie de base (36) et sont connectés à chaque fois à l'extérieur des leviers d'entraînement (33, 33') aux bras oscillants (30, 30').

29. Commande oscillante électrique selon l'une quelconque des revendications 27 ou 28, **caractérisée en ce que** l'actionneur (2) est disposé entre l'arc continu formé par les deux bras d'entraînement (63, 63') et la partie de base (62).

30. Commande oscillante électrique selon l'une quelconque des revendications 27 ou 28, **caractérisée en ce qu'**une partie de socle (65) est fixée à la partie de base (62), laquelle présente un bras de support (67) pour la pompe fluidique (3) au niveau d'un élément de paroi latéral du côté concave de l'arc formé par les deux leviers d'entraînement (63, 63').
